# EUROPEAN PATENT APPLICATION

(11) **EP 2 325 894 A1**
(43) Date of publication of application: **25.05.2011**
(21) Application number: 09811606.4
(22) Date of filing: 08.09.2009
(51) Int. Cl.: H01L 31/042

(54) **SOLAR CELLS, CONCENTRATING SOLAR GENERATOR MODULES, AND SOLAR CELL MANUFACTURING METHOD**

(30) Priority: 08.09.2008 JP 2008230259; 08.09.2008 JP 2008230260
(71) Applicant: Sharp Kabushiki Kaisha, Osaka-shi, Osaka 545-8522 (JP)
(72) Inventor: OKAMOTO, Chikao, Osaka 545-8522 (JP)
(74) Representative: Müller - Hoffmann & Partner
(86) International application number: PCT/JP2009/065658
(87) International publication number: WO 2010/027083

(57) **Abstract**

A photovoltaic cell includes a photovoltaic cell element configured to convert sunlight into electricity, a columnar optical member including an incident surface that the sunlight enters, a side surface by which the sunlight is reflected, and an irradiation surface through which the sunlight is brought to the photovoltaic cell element, and a holder configured to hold the columnar optical member. The holder includes an abutting portion configured to face and abut the columnar optical member, and a non-abutting portion located away from the columnar optical member.

## Description

### Technical Field

The present invention relates to photovoltaic cells, which convert sunlight into electricity, condensing photovoltaic modules including such photovoltaic cells, and methods for manufacturing such photovoltaic cells.

### Background Art

Photovoltaic devices generally have a non-condensing and fixed flat-plate structure in which a photovoltaic module including photovoltaic cell elements that are arranged with no space between them is installed on a roof or the like.

Techniques for reducing the number of photovoltaic cell elements included in the photovoltaic device have been proposed because the photovoltaic cell element costs higher than other members (parts) of the device.

Specifically, there is a proposed technique of condensing sunlight using an optical lens, a reflecting mirror, or the like, and irradiating a small area of photovoltaic cell elements with the condensed sunlight, to increase generated power per unit area of the photovoltaic cell elements, thereby reducing the cost of the photovoltaic cell elements (i.e., the cost of the photovoltaic device) (see, for example, Patent Documents 1-5).

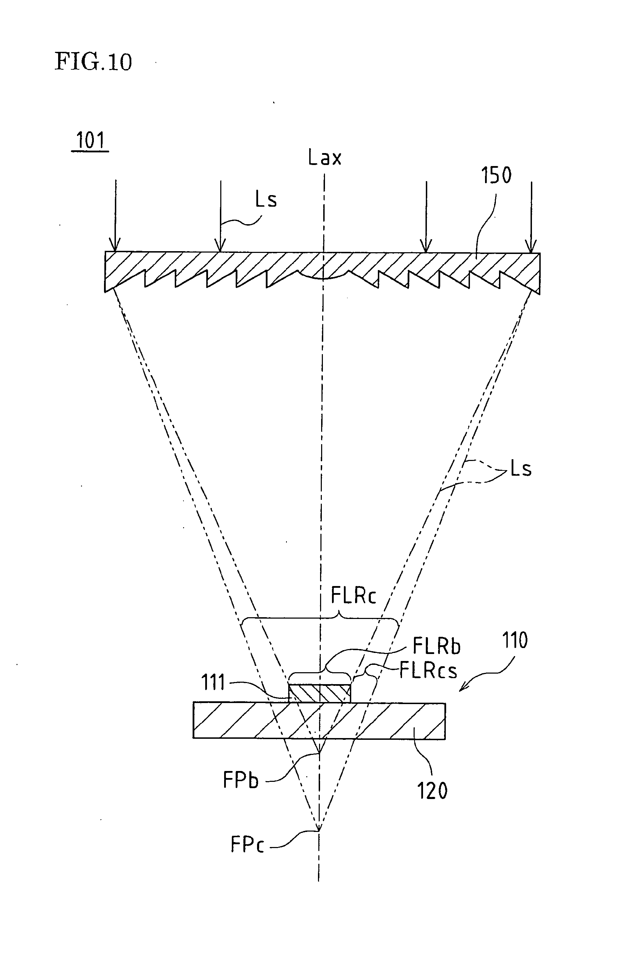

A condensing photovoltaic module used in a conventional condensing photovoltaic device will be described with reference to FIG. 10. FIG. 10 is a cross-sectional diagram showing an exemplary structure of the condensing photovoltaic module used in a conventional tracking condensing photovoltaic device.

The conventional condensing photovoltaic module 101 includes a condensing lens 150 that receives and condenses sunlight Ls that enters a surface (incident surface) thereof closer to the sun in parallel with an optical axis Lax at right angles, and a photovoltaic cell 110 that converts the sunlight Ls condensed by the condensing lens 150 into electricity. Also, the photovoltaic cell 110 includes a photovoltaic cell element 111 that converts the condensed sunlight Ls into electricity, and a receiving substrate 120 on which the photovoltaic cell element 111 is mounted.

Incidentally, the wavelength region of the sunlight Ls includes a short-to-medium wavelength region ranging from 400 nm (short wavelength) to 1,000 nm (1 µm, medium wavelength), and a long wavelength region exceeding 1 µm. The short-to-medium wavelength region of the sunlight Ls condensed by the condensing lens 150 is condensed toward a focus FPb, and this condensed light forms a short-to-medium wavelength condensed light flux region FLRb in the vicinity of the center of the photovoltaic cell element 111. Also, the long wavelength region of the sunlight Ls is condensed toward a focus FPc, and this condensed light forms the short-to-medium wavelength condensed light flux region FLRb and a long wavelength condensed light flux region FLRc spreading around the region FLRb (e.g., around the photovoltaic cell element 111).

Conventional tracking condensing photovoltaic devices employ the condensing photovoltaic module 101 that achieves a high concentration ratio using the condensing lens 150.

Patent Document 1: JP 2002-289896A
Patent Document 2: JP 2002-289897A
Patent Document 3: JP 2002-289898A
Patent Document 4: JP 2006-278581 A
Patent Document 5: JP 2007-201109 A

### Disclosure of Invention

### Problem to be Solved by the Invention

Refraction of the sunlight Ls by the condensing lens 150 slightly varies from wavelength to wavelength within the wide wavelength range of the sunlight Ls. Therefore, the state of refraction largely varies among the wavelength regions within the wide wavelength range. Therefore, as described above, there may be a portion of the sunlight Ls (an outer peripheral region FLRcs of the long wavelength condensed light flux region FLRc) that is not brought to the photovoltaic cell element 111.

Also, for example, an error may occur in alignment of the condensing lens 150 and the photovoltaic cell element 111, or the members of the photovoltaic module 101 may be displaced due to a difference in temperature characteristics between the members. Therefore, as is similar to the case where there are different states of refraction, the irradiation position of the sunlight Ls may be displaced from the center (the optical axis Lax) of the photovoltaic cell element 111 (hereinafter referred to as a positional error or displacement). Specifically, the positional error may occur in the sunlight Ls that should be brought to the photovoltaic cell element 111, so that the efficiency of concentration may change and become lower.

Therefore, the positional error of the sunlight Ls with respect to the photovoltaic cell element 111, which is, for example, caused by the difference in refraction between each wavelength region within the wide wavelength range or the displacement between each member, reduces the effective amount of light entering the photovoltaic cell element 111, resulting in a reduction in the photoelectric conversion efficiency and generated power (output) of the photovoltaic cell 110 (photovoltaic cell element 111), further leading to an unnecessary loss.

Also, if a region other than the photovoltaic cell element 111 is irradiated with the displaced sunlight Ls, a member (e.g., an insulating film, an interconnect, etc. on the receiving substrate 120) of the region irradiated by the thermal energy of the displaced sunlight Ls may have a high temperature, and in some cases, may cause a burnout (destruction).

The present invention has been made in view of the aforementioned circumstances. It is an object of the present invention to provide a photovoltaic cell that is improved in its light concentration efficiency and heat dissipation performance, a condensing photovoltaic module including the photovoltaic cell, and a method for manufacturing the photovoltaic cell.

### Means for Solving Problem

To achieve the object, a photovoltaic cell according to the present invention includes a photovoltaic cell element configured to convert sunlight into electricity, a columnar optical member including an incident surface that the sunlight enters, a side surface by which the sunlight is reflected, and an irradiation surface through which the sunlight is brought to the photovoltaic cell element, and a holder configured to hold the columnar optical member. A facing portion that is faced the columnar optical member of the holder includes an abutting portion configured to abut the columnar optical member, and a non-abutting portion located away from the columnar optical member.

According to the present invention, the sunlight entering the incident surface of the columnar optical member can be efficiently brought through the irradiation surface to the photovoltaic cell element, and thermal energy applied to the columnar optical member and the holder can be dissipated to the holder.

In the above structure, A facing surface that is faced the columnar optical member of the holder may include a holding surface configured to hold a side surface of the columnar optical member, and a side surface exposing recess configured to expose the side surface of the columnar optical member. In this structure, the side surface of the columnar optical member may include a flat surface, and the side surface exposing recess may include a position facing a middle portion of the flat surface.

In this case, the sunlight entering the incident surface of the columnar optical member can be efficiently brought through the irradiation surface to the photovoltaic cell element, and thermal energy applied to the columnar optical member and the holder can be dissipated to the holder. In addition, by exposing the side surface of the columnar optical member in a space formed by the side surface exposing recess, the reflection loss of the incident sunlight that occurs when the sunlight is reflected by the side surface can be reduced, thereby stabilizing the light concentration efficiency. Also, the chimney effect of the space formed by the side surface exposing recess can improve the heat dissipation characteristics. As a result, in the photovoltaic cell, the light concentration characteristics and the heat dissipation characteristics are improved, so that the power generation efficiency and the generated power are improved, and high heat resistance and reliability are obtained.

In the above structure, the facing portion that is faced the columnar optical member of the holder may include a corner holder configured to hold a corner of the columnar optical member, and a side surface exposing recess configured to expose the side surface of the columnar optical member.

In this case, the sunlight entering the incident surface of the columnar optical member can be efficiently brought through the irradiation surface to the photovoltaic cell element, and thermal energy applied to the columnar optical member and the holder can be dissipated to the holder. In addition, by exposing the side surface of the columnar optical member in a space formed by the side surface exposing recess, the reflection loss of the incident sunlight that occurs when the sunlight is reflected by the side surface can be reduced, thereby stabilizing the light concentration efficiency. Also, the chimney effect of the space formed by the side surface exposing recess can improve the heat dissipation characteristics. As a result, in the photovoltaic cell, the light concentration characteristics and the heat dissipation characteristics are improved, so that the power generation efficiency and the generated power are improved, and high heat resistance and reliability are obtained.

Specifically, in the above structure, a receiving substrate on which the photovoltaic cell element is mounted may be provided. The holder may include an abutting frame configured to abut the columnar optical member, a support located away from the columnar optical member and configured to support the abutting frame, and a support mounting member located away from the photovoltaic cell element and configured to mount the support on the receiving substrate.

In this case, thermal energy applied to the columnar optical member and the abutting frame can be dissipated via the abutting frame, the supports, and the support mounting members to the receiving substrate away from the photovoltaic cell element.

In this structure, the abutting frame may be in the shape of a rectangle corresponding to the side surface of the columnar optical member. The holding surface may be extended in a thickness direction of the abutting frame to a position that allows the holding surface to support a gravity center of the columnar optical member.

In this case, the columnar optical member can be reliably and firmly held, whereby the vibration resistance of the columnar optical member can be improved. Therefore, in the photovoltaic cell, the light concentration characteristics can be stabilized and high reliability can be obtained.

In the above structure, the abutting frame may be in the shape of a rectangle corresponding to the side surface of the columnar optical member. The support may be each in the shape of a column extending from the abutting frame. The support mounting member may be extended from the support in parallel with a mounting surface of the receiving substrate and in a direction away from the photovoltaic cell element while abutting the receiving substrate, may be diagonally deflected with respect to a crossing line intersecting a side of the photovoltaic cell element at middle thereof at a right angle, may be arranged at positions rotationally symmetric about a center point of the photovoltaic cell element, and may be fastened to the receiving substrate.

In this case, the abutting frame and the columnar optical member can be accurately positioned. Also, a space can be provided around the photovoltaic cell element and the columnar optical member. The chimney effect of the space can effectively dissipate heat of the photovoltaic cell element and the columnar optical member. Also, heat coming from the columnar optical member 30 can be distributed to the receiving substrate and the surrounding space away from the photovoltaic cell element, and therefore, the photovoltaic cell element is less affected by the heat. Moreover, the heat dissipation characteristics are improved, whereby the photoelectric conversion efficiency and the reliability can be improved. As a result, the thermal energy of the sunlight applied to the columnar optical member and the thermal energy of a long wavelength portion unnecessary for photoelectric conversion of the sunlight applied to the abutting frame can be dissipated via the abutting frame, the supports, and the support mounting members to the receiving substrate and the surrounding space away from the photovoltaic cell element. Therefore, the heat dissipation performance of the photovoltaic cell element and the holder can be improved, whereby the heat dissipation characteristics can be improved, and therefore, the heat resistance, the photoelectric conversion efficiency, and the reliability can be improved.

In the above structure, the side surface of the columnar optical member may be sloped so that the sunlight entering the incident surface is totally reflected toward the irradiation surface. The incident surface of the columnar optical member may be a size to accommodate within an incident surface light flux region formed in the incident surface by a light flux region formed by the sunlight.

In this case, when the position of the sunlight (condensed light flux region) is displaced from the center of the columnar optical member (the incident surface), the incident surface condensed light flux region formed in the incident surface can be reliably located within the incident surface, and the sunlight can be reliably brought through the irradiation surface to the photovoltaic cell element by total reflection from the side surface, whereby variations in the light concentration characteristics can be prevented, resulting in high photoelectric conversion efficiency.

In the above structure, the side surface of the columnar optical member may be sloped by 8-20 degrees with respect to a direction normal to the irradiation surface.

In this case, the sunlight entering the columnar optical member can be reliably and accurately totally reflected by the side surface and brought to the photovoltaic cell element, whereby the light concentration efficiency and the photoelectric conversion efficiency can be improved.

In the above structure, the irradiation surface of the columnar optical member may be of a size to be accommodated within the photovoltaic cell element.

In this case, an unnecessary portion of the sunlight that does not contribute to photoelectric conversion can be prevented from being brought to the receiving substrate, whereby the burnout of the receiving substrate can be prevented, resulting in the photovoltaic cell having high reliability.

In the above structure, a smallest light flux region that is a smallest of light flux regions formed by the sunlight may be located closer to the incident surface of the columnar optical member than a side closer to the photovoltaic cell element.

In this case, the light concentration efficiency and the photoelectric conversion efficiency can be improved.

Also, to achieve the object, a condensing photovoltaic module according to the present invention includes a photovoltaic cell according to the present invention, and a condensing lens configured to condense sunlight and bring the condensed sunlight to the photovoltaic cell.

According to the present invention, when the position of the condensed sunlight (condensed light flux region) is displaced from the center of the columnar optical member (the incident surface), the incident surface condensed light flux region formed in the incident surface can be reliably located within the incident surface, and the condensed sunlight can be reliably brought through the irradiation surface to the photovoltaic cell element by total reflection from the side surface, whereby a reduction in the light concentration efficiency can be prevented. Also, by providing the holder and the receiving substrate, the heat dissipation performance can be improved. Therefore, the condensing photovoltaic module includes the photovoltaic cell having the improved light concentration characteristics and heat dissipation performance, in which the power generation efficiency, the generated power, and the heat resistance, and reliability can be improved.

In the above structure, a smallest light flux region (smallest condensed light flux region) that is a smallest of light flux regions (condensed light flux regions) formed by the sunlight may be located within the columnar optical member.

In this case, a focus group obtained by the condensing lens is located within the columnar optical member, whereby the density of energy in the incident surface condensed light flux region can be suppressed. As a result, it is possible to prevent the burnout of the columnar optical member at the incident surface that would otherwise be caused by high thermal energy, whereby high reliability can be imparted to the condensing photovoltaic module.

In the above structure, the smallest light flux region (smallest condensed light flux region) may be located between a bottom portion of the abutting frame and the incident surface of the columnar optical member.

In this case, total reflection can be caused to occur at a portion of the side surface of the columnar optical member that does not abut the abutting frame, whereby reflection loss that would otherwise be caused by the abutting frame is avoided, and therefore, the light concentration efficiency can be stabilized, resulting in stable output characteristics of the photovoltaic cell.

In the above structure, the abutting frame may be thick enough to block an outer peripheral region of a long wavelength light flux region (long wavelength condensed light flux region) formed by a long wavelength portion of the sunlight

In this case, the long wavelength region (an outer peripheral region of a long wavelength condensed light flux region) of the sunlight can be blocked by the abutting frame, whereby the receiving substrate is prevented from being irradiated with the long wavelength portion of the sunlight. As a result, an increase in the temperature of the receiving substrate can be prevented, thereby improving the photoelectric conversion efficiency.

In the above structure, a focus group including focuses of the condensing lens shifted due to changes in the temperature of the condensing lens, may be located between the bottom portion of the abutting frame and the irradiation surface of the columnar optical member.

In this case, when the focus is shifted due to a change in the temperature of the condensing lens, total reflection can occur in a portion of the side surface that does not abut the abutting frame, whereby the light concentration efficiency can be stabilized, and therefore, the output characteristics of the photovoltaic cell (condensing photovoltaic module) can be stabilized.

In the above structure, an intermittent tracking control may be performed to move a position of the photovoltaic cell to a destination of the sun on the sun's orbit ahead of the sun at predetermined intervals. An incident surface light flux region (incident surface condensed light flux region) formed in the incident surface of the columnar optical member may be located within the incident surface of the columnar optical member.

In this case, even when the intermittent tracking control is performed in which the photovoltaic cell is moved to a destination of the sun ahead of the sun, variations in the light concentration characteristics of the photovoltaic cell can be suppressed, thereby stabilizing the light concentration efficiency. Therefore, the output characteristics of the photovoltaic cell can be stabilized, whereby high reliability can be imparted to the condensing photovoltaic module.

Also, to achieve the object, a photovoltaic cell according to the present invention includes a photovoltaic cell element configured to convert sunlight into electricity, a columnar optical member that condensed sunlight enters, in which the condensed light sunlight is reflected by a side surface thereof, and through that the condensed sunlight is brought to the photovoltaic cell element, and a holder configured to hold the columnar optical member. A facing portion that is faced the columnar optical member of an abutting frame of the holder includes a holding surface configured to hold a side surface of the columnar optical member, and a side surface exposing recess configured to expose the side surface of the columnar optical member. A smallest condensed light flux region that is a smallest of condensed light flux regions formed by the condensed sunlight is located closer to a side on which the photovoltaic cell element is irradiated of the holder than a side on which the sunlight enters of the holder. Also, a condensing photovoltaic module according to the present invention includes the photovoltaic cell of the present invention, and a condensing lens configured to condense sunlight and bring the condensed light to the photovoltaic cell.

According to the present invention, the sunlight condensed in the incident surface can be efficiently brought through the irradiation surface to the photovoltaic cell element, and thermal energy applied to the columnar optical member and the holder can be dissipated via the abutting frame, the support, and the support mounting member to the receiving substrate and the heat sink away from the photovoltaic cell element. In addition, by exposing the side surface of the columnar optical member in a space formed by the side surface exposing recess, the reflection loss of the condensed sunlight that occurs when the condensed sunlight is reflected by the side surface can be reduced, thereby stabilizing the light concentration efficiency. Also, the smallest condensed light flux region is located closer to a side on which the photovoltaic cell element is irradiated of the holder than a side on which the sunlight enters of the holder, whereby the light concentration efficiency can be improved. Also, the chimney effect of the space formed by the side surface exposing recess can improve the heat dissipation characteristics. As a result, in the photovoltaic cell, the light concentration characteristics and the heat dissipation characteristics can be improved, so that the power generation efficiency and the generated power can be improved, and high heat resistance and reliability can be obtained.

Also, to achieve the object, a method is provided for manufacturing a photovoltaic cell according to the present invention. The photovoltaic cell includes a photovoltaic cell element configured to convert sunlight into electricity, a receiving substrate on which the photovoltaic cell element is mounted, a columnar optical member including an incident surface that the sunlight enters, a side surface by which the sunlight is reflected, and an irradiation surface through which the sunlight is brought to the photovoltaic cell element, and a holder configured to hold the columnar optical member. The holder includes an abutting frame configured to abut the columnar optical member, a support located away from the columnar optical member and configured to support the abutting frame, and a support mounting member located away from the photovoltaic cell element and configured to mount the support on the receiving substrate. The method includes a substrate preparing step of preparing the receiving substrate on which the photovoltaic cell element is mounted, a resin sealing member forming step of applying an adhesive resin to the receiving substrate, forming an inner resin sealing adhesive member into inside of which a translucent resin for resin sealing the photovoltaic cell element is injected, and attaching a resin sealing member configured to prevent leakage of the translucent resin to the inner resin sealing adhesive member, a support temporarily fixing step of positioning and temporarily fixing the holder and the receiving substrate to each other, a translucent resin injecting step of injecting the translucent resin into inside of the resin sealing member, a columnar optical member mounting step of causing the columnar optical member to abut the abutting frame to mount the irradiation surface on the translucent resin, a resin sealing member forming step of curing the translucent resin to form the a resin sealing member, and a holder fastening step of fastening the support mounting member to the receiving substrate.

According to the present invention, the columnar optical member that efficiently brings the sunlight entering the incident surface through the irradiation surface to the photovoltaic cell element can be easily and accurately combined with the holder (the abutting frame). Therefore, the holder and the receiving substrate that are used to dissipate the thermal energy of the incident sunlight applied to the columnar optical member at a position away from the photovoltaic cell element, can be easily and accurately assembled. As a result, the photovoltaic cell in which the heat dissipation characteristics and the light concentration characteristics are improved, and high photoelectric conversion efficiency, resistance, and reliability are obtained, can be manufactured with high productivity (i.e., easily and accurately) and low cost.

In the above method, the holder may include a holding surface configured to face and hold a side surface of the columnar optical member, and a side surface exposing recess configured to expose the side surface of the columnar optical member.

In this case, by exposing the side surface of the columnar optical member in a space formed by the side surface exposing recess, the reflection loss of the incident sunlight that occurs when the sunlight is reflected by the side surface can be reduced, thereby stabilizing the light concentration efficiency. Also, the chimney effect of the space formed by the side surface exposing recess can improve the heat dissipation characteristics. As a result, in the photovoltaic cell, the light concentration characteristics and the heat dissipation characteristics are improved, so that the power generation efficiency and the generated power are improved, and high heat resistance and reliability are obtained.

### Effects of the Invention

In the photovoltaic cell of the present invention, the condensing photovoltaic module including the photovoltaic cell, and the method for manufacturing the photovoltaic cell, the light concentration efficiency and the heat dissipation performance can be improved.

### Brief Description of Drawings

[FIG. 1A] FIG. 1A is a cross-sectional view schematically showing structures of a photovoltaic cell and a condensing photovoltaic module according to an embodiment of the present invention, taken along a plane including an optical axis.
[FIG. 1B] FIG. 1B is a perspective view of outer appearances of a holder, a columnar optical member, and a receiving substrate of the photovoltaic cell of FIG. 1A, as viewed obliquely from above.
[FIG. 1C] FIG. 1C is an enlarged cross-sectional view schematically showing a structure of the photovoltaic cell of FIG. 1A.
[FIG. 2] FIG. 2 is a side view showing the concept of characteristics of the photovoltaic cell and the condensing photovoltaic module of the embodiment of the present invention with respect to the wavelengths of sunlight.
[FIG. 3A] FIG. 3A is a conceptual side view of the photovoltaic cell and the condensing photovoltaic module of the embodiment of the present invention, showing shift of a focus with respect to a sunlight wavelength due to temperature characteristics of a condensing lens.
[FIG. 3B] FIG. 3B is a conceptual plan view showing shift of the incident surface condensed light flux region in the incident surface of the photovoltaic cell of FIG. 3A.

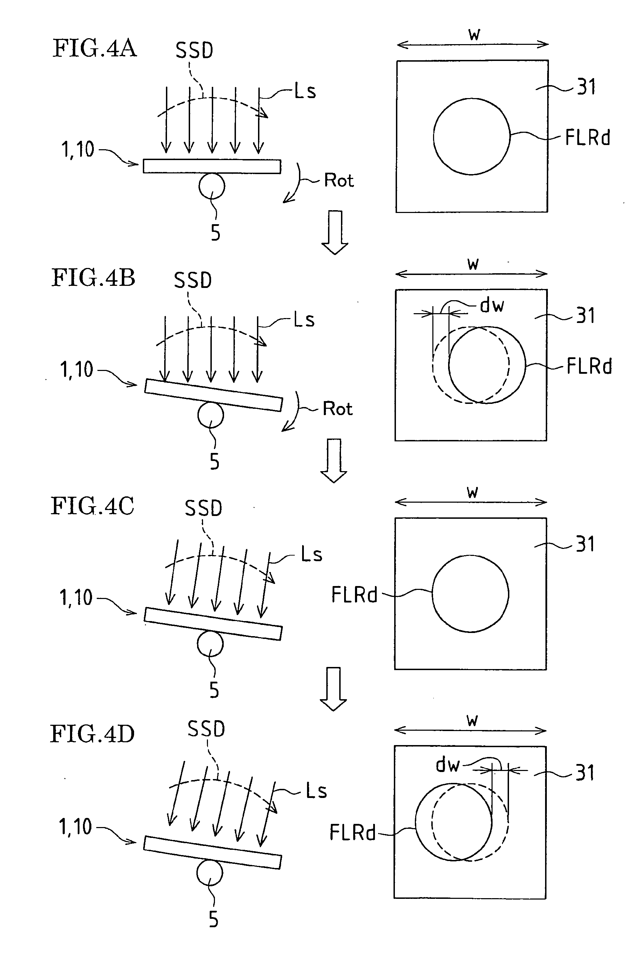

[FIG. 4] FIG. 4 is a tracked state conceptual diagram showing the concept of the relationship between tracked states of the condensing photovoltaic module of the embodiment of the present invention and incident surface condensed light flux regions formed in the incident surface when the condensing photovoltaic module is subjected to an intermittent tracking control. FIG. 4(A) is a diagram showing the condensing photovoltaic module that is normal to sunlight. FIG. 4(B) is a diagram showing the condensing photovoltaic module that has been moved ahead of sunlight. FIG. 4(C) is a diagram showing the condensing photovoltaic module that is normal to sunlight again because of movement of the sunlight. FIG. 4(D) is a diagram showing the condensing photovoltaic module that is lagging behind sunlight because of movement of sunlight.
[FIG. 5] FIG. 5 is a diagram for describing the concept of the relationship between an angular displacement and an incident surface condensed light flux region formed in the incident surface when there is an assembly error between the condensing lens and the photovoltaic cell of the condensing photovoltaic module of the embodiment of the present invention.
[FIG. 6A] FIG. 6A is a perspective view for describing a method for manufacturing the photovoltaic cell of the embodiment of the present invention, where the photovoltaic cell has been mounted on the receiving substrate by die bonding.
[FIG. 6B] FIG. 6B is a perspective view for describing the method for manufacturing the photovoltaic cell of the embodiment of the present invention, where the photovoltaic cell has been subjected to wire bonding.
[FIG. 6C] FIG. 6C is a perspective view for describing the method for manufacturing the photovoltaic cell of the embodiment of the present invention, where an inner resin sealing adhesive member to which a resin sealing member is to be attached has been formed.
[FIG. 6D] FIG. 6D is an exploded perspective view for describing the method for manufacturing the photovoltaic cell of the embodiment of the present invention, where the resin sealing member has not yet been attached to the inner resin sealing adhesive member.
[FIG. 6E] FIG. 6E is an exploded perspective view for describing the method for manufacturing the photovoltaic cell of the embodiment of the present invention, where the holder has not yet been temporarily fixed to the receiving substrate.
[FIG. 6F] FIG. 6F is a plan view of the holder of FIG. 6E as viewed from above.
[FIG. 6G] FIG. 6G is an exploded perspective view for describing the method for manufacturing the photovoltaic cell of the embodiment of the present invention, where a translucent resin has been injected into the inside of the confining member, and the columnar optical member has not yet been mounted on the translucent resin with the columnar optical member abutting the holder and an irradiation surface of the columnar optical member being mounted on the translucent resin.
[FIG. 6H] FIG. 6H is a perspective view for describing the method for manufacturing the photovoltaic cell of the embodiment of the present invention, where the columnar optical member has been mounted on the translucent resin with the columnar optical member abutting the holder and the irradiation surface of the columnar optical member being mounted on the translucent resin.
[FIG. 6J] FIG. 6J is an exploded perspective view for describing the method for manufacturing the photovoltaic cell of the embodiment of the present invention, where the holder, the receiving substrate, and the heat sink have not yet been fastened together.
[FIG. 6K] FIG. 6K is a perspective view for describing the method for manufacturing the photovoltaic cell of the embodiment of the present invention, where the holder, the receiving substrate, and the heat sink have been fastened together.
[FIG. 7A] FIG. 7A is a perspective view of the condensing photovoltaic module of the embodiment of the present invention in which the photovoltaic cell is mounted on a module plate.
[FIG. 7B] FIG. 7B is a perspective view of the condensing photovoltaic module of FIG. 7A in which connectors and connector leads are connected to the photovoltaic cell.
[FIG. 8A] FIG. 8A is a diagram schematically showing a structure of a photovoltaic cell according to another embodiment of the present invention.
[FIG. 8B] FIG. 8B is a schematic cross-sectional view of the holder and the columnar optical member, taken along line A-A of FIG. 8A, indicating how the holder and the columnar optical member abut each other.
[FIG. 9A] FIG. 9A is a diagram schematically showing a structure of a photovoltaic cell according to another embodiment of the present invention.
[FIG. 9B] FIG. 9B is a schematic cross-sectional view of the holder and the columnar optical member, taken along line A-A of FIG. 9A, indicating how the holder and the columnar optical member abut each other.
[FIG. 10] FIG. 10 is a cross-sectional view showing an exemplary structure of a condensing photovoltaic module used in a conventional tracking condensing photovoltaic device.

### Description of the Invention

Embodiments of the present invention will be described hereinafter with reference to the accompanying drawings.

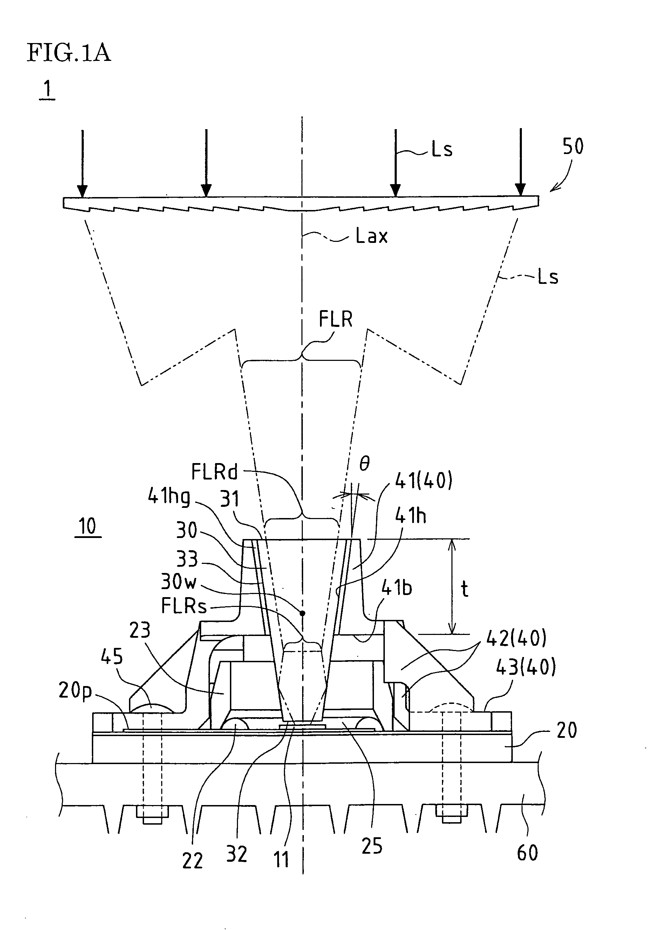

A photovoltaic cell and a condensing photovoltaic module according to this embodiment will be described with reference to FIGS. 1A-1C.

FIG. 1A is a cross-sectional view schematically showing structures of the photovoltaic cell and the condensing photovoltaic module of the embodiment of the present invention, taken along a plane including an optical axis.

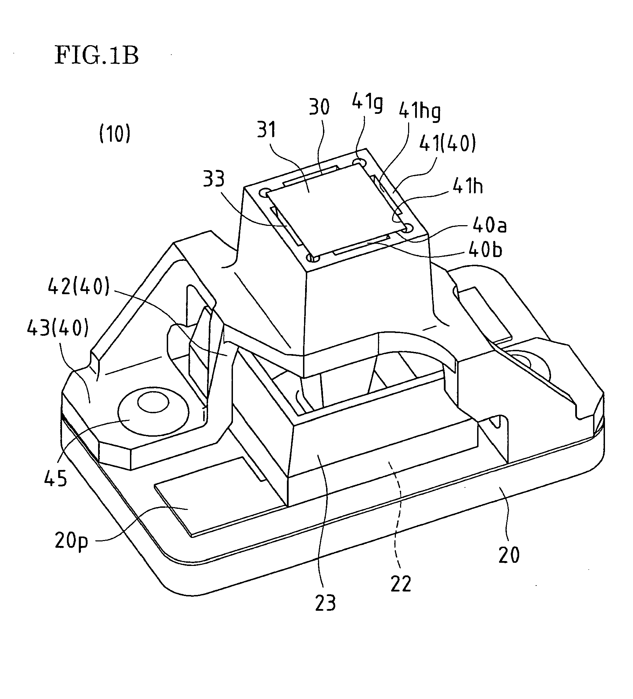

FIG. 1B is a perspective view of outer appearances of a holder, a columnar optical member, and a receiving substrate of the photovoltaic cell of FIG. 1A, as viewed obliquely from above.

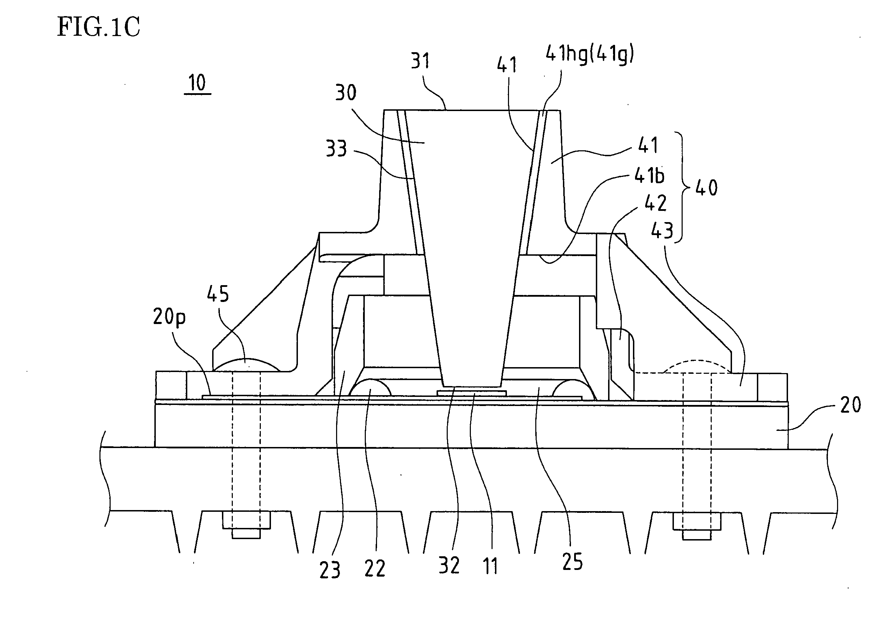

FIG. 1C is an enlarged cross-sectional view schematically showing a structure of the photovoltaic cell of FIG. 1A.

The photovoltaic cell 10 of this embodiment includes a photovoltaic cell element 11 that converts sunlight Ls condensed by a condensing lens 50 into electricity, a receiving substrate 20, a heat sink 60 that dissipates heat coming from the receiving substrate 20, a columnar optical member 30 that has an incident surface 31 that the condensed sunlight Ls enters, side surfaces 33 by which the condensed sunlight Ls is reflected, and an irradiation surface 32 through which the condensed sunlight Ls is brought to the photovoltaic cell element 11, and a holder 40 that holds the columnar optical member 30. The photovoltaic cell element 11 is provided on the receiving substrate 20. The holder 40 is arranged to stand on the receiving substrate 20.

The irradiation surface 32 of the columnar optical member 30 is arranged to face the photovoltaic cell element 11. Also, the side surface 33 of the columnar optical member 30 includes a flat surface.

As shown in FIG. 1B, the holder 40 includes, at portions thereof facing the columnar optical member 30, abutting portions 40a that abut the columnar optical member 30 and non-abutting portions 40b that are located away from the columnar optical member 30. Specifically, the holder 40 includes an abutting frame 41 that abuts the side surfaces 33 of the columnar optical member 30 and has a thickness t in a direction from the incident surface 31 toward the irradiation surface 32, supports 42 that are located away from the columnar optical member 30 and support the abutting frame 41, and support mounting members 43 that abut the receiving substrate 20 while extending in parallel with the receiving substrate 20 outside the abutting frame 41, and are used to mount the supports 42 on the receiving substrate 20.

Also, the abutting frame 41 of the holder 40 includes, in surfaces thereof facing the side surfaces 33 of the columnar optical member 30, holding surfaces 41h that abut the side surfaces 33 of the columnar optical member 30 to hold the side surfaces 33, and side surface exposing recesses 41hg in which the side surfaces 33 of the columnar optical member 30 are exposed. Note that the side surface 33 of the columnar optical member 30 and the holding surface 41h of the abutting frame 41 are flat surfaces abutting each other, and the columnar optical member 30 and the abutting frame 41 can be accurately positioned by causing them to abut each other.

The side surface exposing recess 41hg has a depth in the thickness-t direction of the abutting frame 41. The exposing recess 41hg provides a space in which the side surface 33 is exposed. The side surface exposing recess 41hg includes a position facing a center portion of the side surface 33 (flat surface) of the columnar optical member 30.

With this structure, the condensed sunlight Ls entering the incident surface 31 of the columnar optical member 30 can be efficiently brought through the irradiation surface 32 to the photovoltaic cell element 11. Also, thermal energy of the sunlight Ls applied to the columnar optical member 30 and the abutting frame 41 can be dissipated via the abutting frame 41, the supports 42, and the support mounting members 43 of the holder 40 to the receiving substrate 20 away from the photovoltaic cell element 11. Moreover, the thermal energy of the sunlight Ls applied to the columnar optical member 30 and the abutting frame 41 can be dissipated from the receiving substrate 20 to the heat sink 60. Also, because the side surfaces 33 of the columnar optical member 30 are exposed in the spaces of the side surface exposing recesses 41hg, the reflection loss of the condensed sunlight Ls that occurs when the condensed sunlight Ls is reflected by the side surfaces 33 can be reduced, thereby stabilizing the light concentration efficiency. Also, the chimney effect of the space formed by the side surface exposing recess 41hg can improve the heat dissipation characteristics. As a result, according to the photovoltaic cell 10, the light concentration characteristics and the heat dissipation characteristics are improved, so that the power generation efficiency and the generated power are improved, and high heat resistance and reliability are obtained.

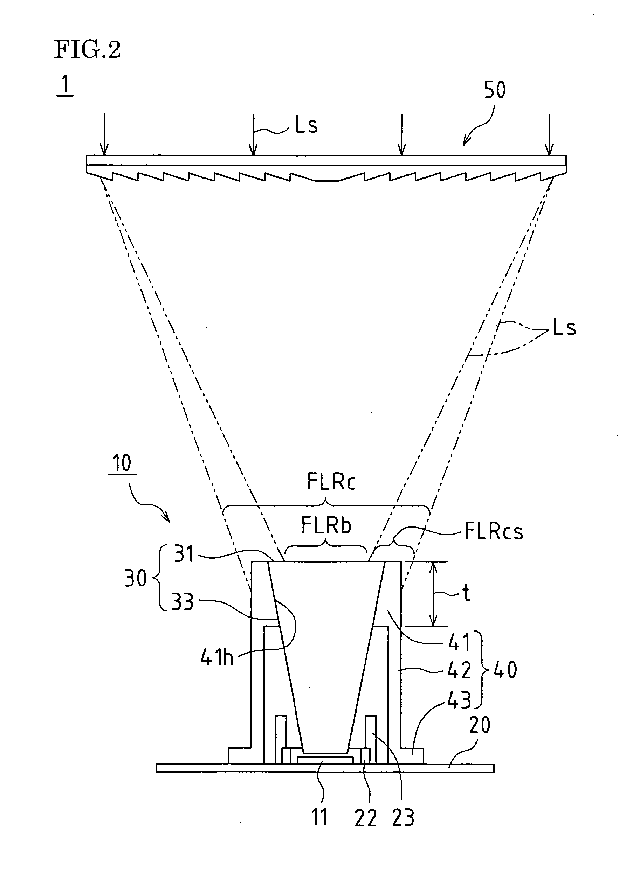

Specifically, according to the photovoltaic cell 10, the heat dissipation performance of the photovoltaic cell element 11 and the holder 40 are improved (heat dissipation characteristics are improved), and the light concentration characteristics are improved, resulting in high photoelectric conversion efficiency, resistance, and reliability. Note that the effect on the sunlight Ls having a long wavelength will be described below in detail with reference to FIG. 2.

As described above, the side surface exposing recess 41hg is formed in the holding surface 41h of the abutting frame 41 that holds the columnar optical member 30. Therefore, the side surface 33 of the columnar optical member 30 is exposed in the space formed by the side surface exposing recess 41hg. Also, the side surface exposing recess 41hg has a depth in the thickness-t direction of the abutting frame 41, so that an effective chimney effect is provided. Therefore, the thermal energy of the sunlight Ls supplied to the columnar optical member 30 can be efficiently discharged to the space.

Also, heat applied to the holder 40 (the abutting frame 41) by unnecessary sunlight can be dissipated from the abutting frame 41 via the supports 42 and the support mounting members 43 to the receiving substrate 20 and the heat sink 60 away from the photovoltaic cell element 11. Specifically, the long wavelength region of the sunlight Ls that is not necessary for photoelectric conversion is blocked by the abutting frame 41, whereby the thermal energy of the unnecessary long wavelength portion of the sunlight Ls applied to the abutting frame 41 can be efficiently dissipated via the supports 42, the support mounting members 43, the receiving substrate 20, and the heat sink 60. Therefore, the photovoltaic cell element 11 is not affected by the heat of the holder 40, and therefore, the heat resistance of the photovoltaic cell 10 (the photovoltaic cell element 11) can be improved.

The abutting frame 41 is formed in the shape of a rectangle corresponding to the side surface 33 of the columnar optical member 30. The holding surface 41h is extended in the thickness-t direction of the abutting frame 41 to a position that allows the holding surface 41h to support the gravity center 30w of the columnar optical member 30. Therefore, the columnar optical member 30 can be reliably and firmly held, whereby the vibration resistance of the columnar optical member 30 can be improved, and therefore, stable light concentration characteristics and high reliability can be imparted to the photovoltaic cell 10.

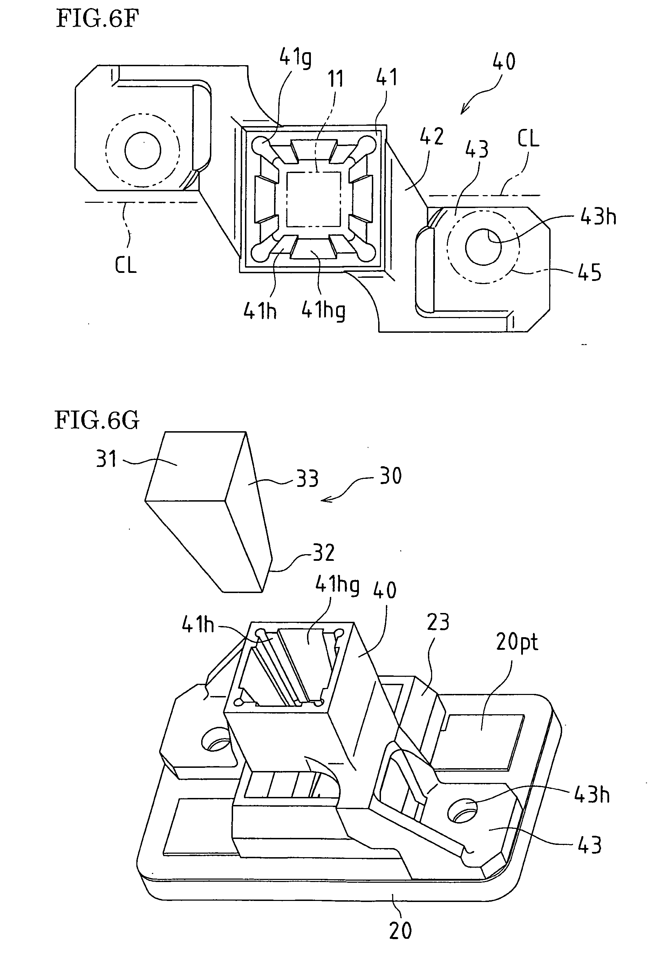

The supports 42 have a columnar shape extending from the abutting frame 41. The support mounting members 43 extend outside the abutting frame 41 in parallel with the receiving substrate 20 and abut the receiving substrate 20. The support mounting members 43 are arranged at rotationally symmetric positions diagonally aligned with respect to a crossing line CL intersecting opposite sides of the photovoltaic cell element 11 at middles thereof at right angles (see FIG. 6F), and are fastened to the receiving substrate 20 and the heat sink 60 by fastening members 45. In other words, the support mounting members 43, the receiving substrate 20, and the heat sink 60 are integrated together by the fastening members 45. Note that examples of the fastening member 45 include rivets, screws, and the like.

Therefore, the abutting frame 41 (the holder 40) and the columnar optical member 30 can be accurately positioned. Also, a space (e.g., a space between a bottom portion 41b of the abutting frame 41 and a resin sealing member 25, or a space between the side surface exposing recess 41hg and the side surface 33) is provided around the photovoltaic cell element 11 and the columnar optical member 30 (the side surfaces 33). The chimney effect of the space can effectively dissipate heat of the photovoltaic cell element 11 and the columnar optical member 30. Also, heat coming from the columnar optical member 30 can be distributed to the receiving substrate 20, the heat sink 60, and the surrounding space away from the photovoltaic cell element 11, and therefore, the photovoltaic cell element 11 is less affected by the heat. Moreover, the heat dissipation characteristics are improved, whereby the photoelectric conversion efficiency and the reliability can be improved.

As described above, in the photovoltaic cell 10 of this embodiment, the thermal energy of the condensed sunlight Ls applied to the columnar optical member 30 and the thermal energy of the long wavelength portion (not necessary for photoelectric conversion) of the sunlight Ls applied to the abutting frame 41 (the holder 40) can be dissipated from the abutting frame 41 via the supports 42 and the support mounting members 43 to the receiving substrate 20, the heat sink 60, and the surrounding space away from the photovoltaic cell element 11.

Thus, thermal energy coming from the columnar optical member 30 and the holder 40 can be prevented from affecting the photovoltaic cell element 11, whereby the heat dissipation performance of the photovoltaic cell element 11 and the holder 40 can be improved, and therefore, the heat dissipation characteristics can be improved. As a result, the heat resistance, the photoelectric conversion efficiency, and the reliability can be improved.

Also, corner recesses 41g corresponding to the corners of the columnar optical member 30 are provided in inner corner portions of the abutting frame 41 (where the holding surfaces 41h intersect and which abut corner portions of the columnar optical member 30). Therefore, the corners of the columnar optical member 30 are located in spaces formed by the corner recesses 41g, and therefore, do not directly contact the abutting frame 41 and are not likely to be damaged during assembly. Also, the side surfaces 33 and the holding surfaces 41h of the abutting frame 41 are flat surfaces, and therefore, can be caused to accurately abut each other, resulting in accurate positioning.

The side surfaces 33 of the columnar optical member 30 are sloped so that the incident sunlight Ls is totally reflected toward the irradiation surface 32. The incident surface 31 of the columnar optical member 30 is of a size to accommodate an incident surface condensed light flux region FLRd that is formed in the incident surface 31 by a condensed light flux region FLR formed by the condensed sunlight Ls (i.e., the incident surface condensed light flux region FLRd is located within the incident surface 31).

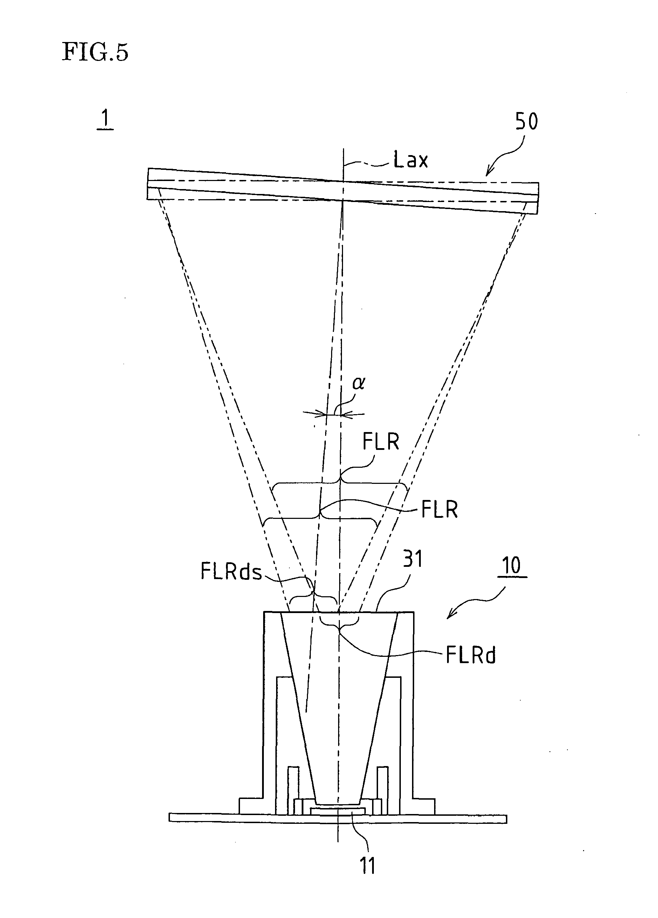

Therefore, even if the position of the condensed sunlight Ls (the condensed light flux region FLR, a light flux region as used herein) is displaced from the center (the optical axis Lax) of the columnar optical member 30 (the incident surface 31) (see FIGS. 4 and 5), the incident surface condensed light flux region FLRd (an incident surface light flux region as used herein) formed in the incident surface 31 can be reliably located within the incident surface 31, and the condensed sunlight Ls can be reliably brought through the irradiation surface 32 to the photovoltaic cell element 11 by total reflection from the side surfaces 33. As a result, variations in the light concentration characteristics of the photovoltaic cell 10 can be prevented, thereby achieving high photoelectric conversion efficiency.

Also, heat of the condensed sunlight Ls applied to the columnar optical member 30 can be distributed to the surrounding space by the side surfaces 33 and the abutting frame 41, resulting in the photovoltaic cell 10 in which the light concentration efficiency and the photoelectric conversion efficiency are improved, and high heat resistance and reliability are obtained.

The side surface 33 of the columnar optical member 30 is sloped by an angle θ of 8-20 degrees with respect to the normal direction of the irradiation surface 32 (the direction of the optical axis Lax, i.e., a direction normal to the light receiving surface of the photovoltaic cell element 11). Therefore, the sunlight Ls entering the columnar optical member 30 can be reliably and accurately totally reflected by the side surfaces 33 and then brought to the photovoltaic cell element 11, whereby the light concentration efficiency and the photoelectric conversion efficiency of the photovoltaic cell 10 can be reliably improved.

Specifically, a region of the side surface 33 of the columnar optical member 30 where total reflection is performed, i.e., a region extending from the bottom portion 41b of the abutting frame 41 to the irradiation surface 32, does not abut the abutting frame 41 and is exposed to the space. Therefore, the thermal energy of the sunlight Ls supplied to the columnar optical member 30 can be efficiently discharged to the space.

The irradiation surface 32 of the columnar optical member 30 is formed of a size to be located or accommodated within the photovoltaic cell element 11 (within the outer circumference thereof). Therefore, the sunlight Ls brought through the irradiation surface 32 to the photovoltaic cell element 11 is reliably brought to only the photovoltaic cell element 11. In other words, an unnecessary portion of the sunlight Ls that does not contribute to photoelectric conversion can be prevented from being brought to the receiving substrate 20, whereby the burnout of the receiving substrate 20 on which interconnect patterns 20p for the photovoltaic cell element 11 are formed can be prevented, resulting in the photovoltaic cell 10 having high reliability.

The columnar optical member 30 can be made of, for example, glass, heat-resistant glass, a general transparent resin, or the like. A material that is resistant to a high energy density possessed by the condensed sunlight Ls is preferable. Specifically, heat-resistant glass, which is resistant to an increase or a rapid change in temperature due to the sunlight Ls, is particularly preferable, although the present invention is not limited to this.

Also, the thermal energy of the condensed sunlight Ls applied to the columnar optical member 30 and the thermal energy of unnecessary sunlight applied to the holder 40 (the abutting frame 41) can be dissipated from the abutting frame 41 via the supports 42 and the support mounting members 43 to the receiving substrate 20 and the heat sink 60, thereby preventing the thermal energy coming from the holder 40 from affecting the photovoltaic cell element 11, so that the heat resistance of the photovoltaic cell element 11 can be improved.

Also, the corner recesses 41g corresponding to the corners of the columnar optical member 30 are formed in the inner corner portions of the abutting frame 41 (the columnar optical member 30 abuts the inner surfaces of the abutting frame 41). In other words, the corners of the columnar optical member 30 are located in the spaces formed by the corner recesses 41g, and therefore, do not directly contact the abutting frame 41 and are not likely to be damaged during assembly. Also, the side surfaces 33 of the columnar optical member 30 and the inner surfaces of the abutting frame 41 are flat surfaces, and therefore, can be caused to accurately abut each other, resulting in accurate positioning.

Also, the holder 40 can be made of, for example, a metal, such as aluminum, iron, stainless steel, or the like, a synthetic resin, such as polyethylene or the like, etc. Metals are preferable in terms of heat dissipation performance, thermal expansion characteristics, or the like. Also, aluminum is preferable in terms of weight reduction and cost reduction.

Note that the corner recess 41g may be filled with an adhesive resin to improve the bonding strength between the columnar optical member 30 and the holder 40 (the abutting frame 41), thereby improving the mechanical strength and therefore improving the stability of the columnar optical member 30. Also, a smallest condensed light flux region FLRs (a smallest light flux region as used herein) that is a smallest of the condensed light flux region FLR is located close to the irradiation surface 32 of the columnar optical member 30 with respect to the abutting frame 41. Therefore, the sunlight Ls does not impinge on the side surfaces 33 of the columnar optical member 30 inside the abutting frame 41, so that the sunlight Ls is not affected at all. In other words, even when the corner recesses 41g are filled with an adhesive resin, the light concentration characteristics are not adversely affected.

An inner resin sealing adhesive member 22 in the shape of a ring (frame) is formed around the photovoltaic cell element 11 mounted on the receiving substrate 20 by applying an adhesive resin on the receiving substrate 20. The inner resin sealing member 23 is attached (mounted) on the inner resin sealing adhesive member 22. Also, the resin sealing member 25 made of a translucent resin is formed inside the inner resin sealing member 23 (the inner resin sealing adhesive member 22) to fill a space between the photovoltaic cell element 11 and the irradiation surface 32 of the columnar optical member 30.

In other words, the inner resin sealing member 23 (the inner resin sealing adhesive member 22) is used to confine the translucent resin and prevent leakage thereof when the space between the photovoltaic cell element 11 and the irradiation surface 32 of the columnar optical member 30 is filled with the translucent resin to form the resin sealing member 25.

The resin sealing member 25 can reliably protect the surface of the photovoltaic cell element 11 from the influence of an external environment, whereby excellent weatherability and high reliability can be imparted to the photovoltaic cell 10.

The translucent resin of the resin sealing member 25 preferably has a high transmittance and exhibits excellent adhesion. Examples of the translucent resin include epoxy resins, silicone resins, and the like. The resin sealing member 25 covers the surface of the photovoltaic cell element 11 to improve the water resistance and moisture resistance of the photovoltaic cell element 11. Also, the resin sealing member 25 is attached to the columnar optical member 30 (the irradiation surface 32), and therefore, fixes the columnar optical member 30.

The condensing photovoltaic module 1 of this embodiment includes the condensing lens 50 that condenses the sunlight Ls and brings the condensed sunlight Ls to the photovoltaic cell 10, and the photovoltaic cell 10 that converts the sunlight Ls condensed by the condensing lens 50 into electricity. According to the condensing photovoltaic module 1 of this embodiment, when the position of the condensed sunlight Ls (the condensed light flux region FLR) is displaced from the center (the optical axis Lax) of the columnar optical member 30 (the incident surface 31), the incident surface condensed light flux region FLRd formed in the incident surface 31 is reliably located within the incident surface 31, and the condensed sunlight Ls is reliably brought through the irradiation surface 32 to the photovoltaic cell element 11 by total reflection from the side surfaces 33, whereby a reduction in light concentration efficiency can be prevented. Also, the holder 40, the receiving substrate 20, and the heat sink 60 can be used to improve the heat dissipation performance. In addition, the side surface exposing recesses 41hg can be used to reduce reflection loss on the side surfaces 33 of the columnar optical member 30, resulting in stable light concentration efficiency. Also, the chimney effect of the side surface exposing recesses 41hg can improve the heat dissipation characteristics. As a result, the condensing photovoltaic module 1 that includes the photovoltaic cell 10 having the improved light concentration characteristics and heat dissipation performance can be improved in the power generation efficiency and the generated power and can also be provided with heat resistance and reliability.

Therefore, in the condensing photovoltaic module 1 of this embodiment, even if the position of the incident surface condensed light flux region FLRd is displaced from the center of the incident surface 31 (the optical axis Lax), the light concentration efficiency is not likely to decrease. Also, heat dissipation performance can be ensured for an unnecessary portion of the sunlight Ls, whereby the light concentration efficiency and the conversion efficiency can be improved, and high heat resistance and reliability can be obtained.

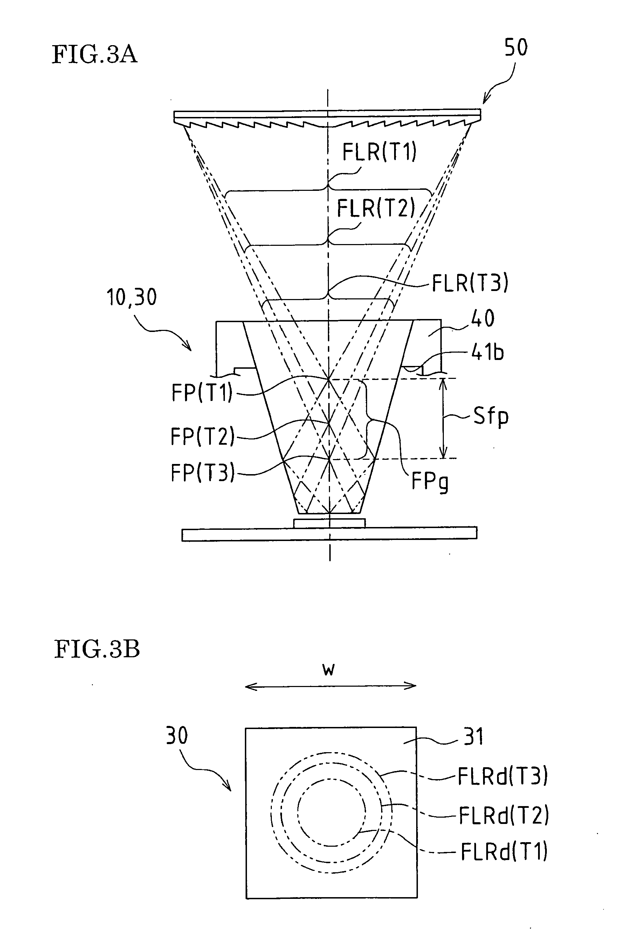

Also, the smallest condensed light flux region FLRs that is a smallest of the condensed light flux region FLR is located within the columnar optical member 30. Therefore, a focus group FPg (see FIG. 3A) obtained by the condensing lens 50 is located within the columnar optical member 30, whereby the density of energy in the incident surface condensed light flux region FLRd can be suppressed. As a result, it is possible to prevent the burnout of the columnar optical member 30 at the incident surface 31 that would otherwise be caused by high thermal energy, whereby high reliability can be imparted to the condensing photovoltaic module 1.

Specifically, for example, when dust is attached to the incident surface 31 of the columnar optical member 30, the dust is prevented from being burnt by high thermal energy of the condensed sunlight Ls to cause the burnout of the columnar optical member 30, whereby high reliability can be imparted to the condensing photovoltaic module 1.

The smallest condensed light flux region FLRs is preferably located between the bottom portion 41b of the abutting frame 41 and the incident surface 31 of the columnar optical member 30. With this structure, total reflection can be caused to occur at a portion of the side surface 33 of the columnar optical member 30 that does not abut the abutting frame 41 (the holding surface 41h), whereby reflection loss that would otherwise be caused by the abutting frame 41 is avoided, and therefore, the light concentration efficiency can be stabilized, resulting in stable output characteristics of the photovoltaic cell 10.

In other words, the region in the side surface 33 of the columnar optical member 30 where total reflection occurs is a region extending from the bottom portion 41b of the abutting frame 41 to the irradiation surface 32, where the side surface 33 of the columnar optical member 30 does not abut the abutting frame 41 (the holding surface 41h) and is exposed to the space. Therefore, the thermal energy of the sunlight Ls supplied to the columnar optical member 30 can be efficiently discharged to the space.

Note that the size of the incident surface condensed light flux region FLRd can be set by calculating, based on optics, the light concentration characteristics, size, and distance of the condensing lens 50 with respect to the photovoltaic cell 10. Also, the size and location of the smallest condensed light flux region FLRs can be set by calculating, based on optics, the light concentration characteristics, size, and distance of the condensing lens 50 with respect to the photovoltaic cell 10, and further, the size and distance of the columnar optical member 30 with respect to the photovoltaic cell element 11.

Next, characteristics of the photovoltaic cell and the condensing photovoltaic module of this embodiment with respect to the wavelengths of sunlight will be described with reference to FIG. 2.

FIG. 2 is a side view showing the concept of the characteristics of the photovoltaic cell and the condensing photovoltaic module of this embodiment with respect to the wavelengths of sunlight. Note that, in the figures described below, the structures of the photovoltaic cell and the condensing photovoltaic module may be simplified.

The wavelength region of the sunlight Ls includes a short-to-medium wavelength region ranging from 400 nm (short wavelength) to 1,000 nm (1 µm, medium wavelength), and a long wavelength region exceeding 1 µm. The short-to-medium wavelength region of the sunlight Ls condensed by the condensing lens 50 forms a short-to-medium wavelength condensed light flux region FLRb in the vicinity of the center of the incident surface 31. Also, the long wavelength region of the sunlight Ls forms the short-to-medium wavelength condensed light flux region FLRb and a long wavelength condensed light flux region FLRc spreading around the region FLRb (e.g., around the incident surface 31, and in a region corresponding to the abutting frame 41).

The short-to-medium wavelength region (400-1,000 nm) of the sunlight Ls directly contributes to the photoelectric conversion of the photovoltaic cell element 11. Therefore, the short-to-medium wavelength condensed light flux region FLRb formed by the short-to-medium wavelength region (400-1,000 nm) is reliably brought to the photovoltaic cell element 11.

In this embodiment, the short-to-medium wavelength condensed light flux region FLRb enters the incident surface 31 of the columnar optical member 30, travels inside the columnar optical member 30, and is totally reflected by the side surfaces 33. In other words, the incident surface 31 of the columnar optical member 30 accommodates the short-to-medium wavelength condensed light flux region FLRb. Conversely, the short-to-medium wavelength condensed light flux region FLRb is located within the incident surface 31 by the condensing lens 50.

On the other hand, not all the long wavelength region (more than 1 µm) of the sunlight Ls contributes to the photoelectric conversion of the photovoltaic cell element 11, and about two thirds of the incident energy may need to contribute to the photoelectric conversion. Also, the long wavelength region of the sunlight Ls increases the temperature of the photovoltaic cell 10, leading to a reduction in the photoelectric conversion efficiency.

Therefore, in this embodiment, an outer peripheral portion (the outer peripheral region FLRcs outside the short-to-medium wavelength condensed light flux region FLRb) of the long wavelength condensed light flux region FLRc that is a condensed light flux region formed by the long wavelength region (more than 1 µm) of the sunlight Ls, is blocked by the abutting frame 41 (the thickness t). In other words, the outer peripheral region FLRcs of the long wavelength condensed light flux region FLRc formed by the long wavelength region of the sunlight Ls is condensed and brought by the condensing lens 50 to a region around the incident surface 31 of the columnar optical member 30, and is blocked by the top surface and a region corresponding to the thickness t of the abutting frame 41.

Specifically, the thickness t of the abutting frame 41 is such that the outer peripheral region FLRcs of the long wavelength condensed light flux region FLRc formed by the long wavelength region of the sunlight Ls is blocked. With this structure, the long wavelength region of the sunlight Ls is blocked by the abutting frame 41, whereby the receiving substrate 20 is prevented from being irradiated with the sunlight Ls. As a result, an increase in the temperature of the receiving substrate 20 can be prevented, thereby improving the photoelectric conversion efficiency. Note that the holding surface 41h of the abutting frame 41 is formed to correspond to the thickness t of the abutting frame 41.

Incidentally, when the photovoltaic cell element 11 is a multijunction photovoltaic cell, the designed current value of the bottom layer is about 1.8 times as high as those of the top and middle layers. Therefore, not all the wavelength regions need to be absorbed. Therefore, by causing the top surface and the thickness-t portion of the abutting frame 41 to have a function of blocking light in the long wavelength region, the temperature increase that would otherwise be caused by the long wavelength region of the sunlight Ls can be prevented. Also, conversely, by accurately positioning the incident surface condensed light flux region FLRd (the short-to-medium wavelength condensed light flux region FLRb) corresponding to the short-to-medium wavelength region into the incident surface 31 of the columnar optical member 30, and causing the incident surface condensed light flux region FLRd to be totally reflected by the side surfaces 33 of the columnar optical member 30, the heat blocking effect can be exhibited, whereby a reduction in output due to the positional error of the incident surface condensed light flux region FLRd can be prevented to ensure a stable output.

Next, the photovoltaic cell and the condensing photovoltaic module of this embodiment will be further described with reference to FIGS. 3A and 3B.

FIG. 3A is a conceptual side view of the photovoltaic cell and the condensing photovoltaic module of the embodiment of the present invention, showing shift of a focus with respect to a sunlight wavelength due to temperature characteristics of the condensing lens.

FIG. 3B is a conceptual plan view showing shift of the incident surface condensed light flux region in the incident surface of the photovoltaic cell of FIG. 3A.

The condensing lens 50 of this embodiment is, for example, a Fresnel lens made of a silicone resin. For example, when the temperature of the silicone resin is changed from 20°C to 40°C, the refraction index with respect to a wavelength of 650 nm correspondingly changes from 1.409 (20°C) to 1.403 (40°C). Note that the refraction index changes for all wavelengths.

Therefore, the condensed light flux region FLR varies with temperature. For example, when a temperature T1 >a temperature T2>a temperature T3, the condensed light flux region FLR(T1) at the temperature T1 < the condensed light flux region FLR(T2) at the temperature T2 < the condensed light flux region FLR(T3) at the temperature T3. Also, the incident surface condensed light flux region FLRd(T1) at the temperature T1, the incident surface condensed light flux region FLRd(T2) at the temperature T2, and the incident surface condensed light flux region FLRd(T3) at the temperature T3, have the following relationship: the incident surface condensed light flux region FLRd(T1) < the incident surface condensed light flux region FLRd(T2) < the incident surface condensed light flux region FLRd(T3).

In other words, the focus FP(T1) at the temperature T1, the focus FP(T2) at the temperature T2, and the focus FP(T3) at the temperature T3, are located in the following order from the incident surface 31: the focus FP(T1), the focus FP(T2), and the focus FP(T3). Therefore, the focus FP(T1), the focus FP(T2), and the focus FP(T3) are a set of focuses FP, i.e., the focus group FPg.

Specifically, when the temperature of the condensing lens 50 is varied within the range from the temperature T1 to the temperature T3, the focus FP makes focus shifts Sfp, which cause variations in the light concentration characteristics of the condensing lens 50. Also, the incident surface condensed light flux region FLRd in the incident surface 31 is varied due to the influence of variations in the refraction index.

The diameter of the condensing lens 50 is, for example, 30 cm. The distance between the condensing lens 50 and the photovoltaic cell element 11 is, for example, 30 cm. In this case, when the incident surface condensed light flux region FLRd(T1) at the temperature T1 (e.g., 40°C) has a diameter of about 6.5 mm, the incident surface condensed light flux region FLRd(T2) at the temperature T2 (e.g., 30°C) has a diameter of about 7 mm, and the incident surface condensed light flux region FLRd(T3) at the temperature T3 (e.g., 20°C) has a diameter of about 7.5 mm, then if the incident surface 31 in the shape of a rectangle has a side length w of, for example, 9.4 mm, the incident surface condensed light flux region FLRd is invariably located within the incident surface 31 even if there is a change in the light concentration characteristics accompanying a change in the temperature, whereby variations in the light concentration characteristics can be substantially prevented.

Also, in this case, the focus shift Sfp from the focus FP(T1) to the focus FP(T3) is about 10 mm. Therefore, the distance between the bottom portion 41b of the abutting frame 41 and the irradiation surface 32 of the columnar optical member 30 may need to be at least 10 mm or more.

As described above, in this embodiment, the focus group FPg including the focuses FP of the condensing lens 50 shifted due to changes in the temperature of the condensing lens 50, is located between the bottom portion 41b of the abutting frame 41 and the irradiation surface 32 of the columnar optical member 30. Therefore, when the focus is shifted due to a change in the temperature of the condensing lens 50, total reflection can occur in a portion of the side surface 33 that does not abut the abutting frame 41, whereby the light concentration efficiency can be stabilized, and therefore, the output characteristics of the photovoltaic cell 10 can be stabilized.

Also, because the focus FP is located between the bottom portion 41b of the abutting frame 41 and the irradiation surface 32 of the columnar optical member 30, the position of the focus FP is prevented from being shifted to a position corresponding to the outer periphery of the holder 40. Therefore, even if the sunlight Ls is exceptionally brought to the receiving substrate 20, the thermal energy density of the condensed light flux region FLR at the surface of the receiving substrate 20 can be suppressed, whereby an increase in the temperature of the receiving substrate 20 can be prevented, and therefore, the burnout of the receiving substrate 20 can be avoided.

Next, a tracking condensing photovoltaic cell and a condensing photovoltaic module will be described with reference to FIG. 4.

FIG. 4 is a tracked state conceptual diagram showing the concept of the relationship between tracked states of the condensing photovoltaic module of the embodiment of the present invention and incident surface condensed light flux regions formed in the incident surface when the condensing photovoltaic module is subjected to an intermittent tracking control. FIG. 4(A) is a diagram showing the condensing photovoltaic module that is normal to sunlight. FIG. 4(B) is a diagram showing the condensing photovoltaic module that has been moved ahead of sunlight. FIG. 4(C) is a diagram showing the condensing photovoltaic module that is normal to sunlight again because of movement of the sunlight. FIG. 4(D) is a diagram showing the condensing photovoltaic module that is lagging behind sunlight because of movement of sunlight.

The condensing photovoltaic module 1 of this embodiment (the photovoltaic cell 10) is caused to be normal to the sunlight Ls by a so-called tracking control. Specifically, the direction of incidence of the sunlight Ls with respect to the condensing photovoltaic module 1 (the incident surface 31) varies along the direction of the sun's movement SSD. Therefore, the condensing photovoltaic module 1 is intermittently driven and turned according to the sun's azimuth angle, and intermittently driven and inclined according to the sun's attitude, by a tracking controller 5. Although FIG. 4 shows only turning movements for the sake of ease of understanding, inclining movements are also performed by a similar drive control along with the turning movements.

In order to efficiently perform the tracking control, the tracking control is applied to the condensing photovoltaic module 1 at predetermined intervals. In other words, the tracking controller 5 performs a so-called intermittent tracking control. Note that the condensing photovoltaic module 1 has a shape (the diameter of the condensing lens 50, and the distance between the condensing lens 50 and the photovoltaic cell element 11) shown in FIG. 4.

The intermittent tracking control can be, for example, performed as follows.

The condensing photovoltaic module 1 is driven and turned in a direction indicated by an arrow Rot from a position where the condensing photovoltaic module 1 is lagging behind the sunlight Ls (immediately before FIG. 4(A)), to pass through a state in which the condensing photovoltaic module 1 is normal to the sunlight Ls (FIG. 4(A)), and reach and be fixed to a state in which the condensing photovoltaic module 1 is preceding the sunlight Ls (FIG. 4(B)).

The maximum turn angle of the condensing photovoltaic module 1 that is preceding the sunlight Ls is, for example, +0.05 degrees with respect to a position (normal position) where the condensing photovoltaic module 1 is normal to the sunlight Ls. When the side length w of the incident surface 31 is 9.4 mm and the diameter of the incident surface condensed light flux region FLRd is 7 mm, the incident surface condensed light flux region FLRd is displaced by a distance of 1 mm (turning displacement dw) from that which is obtained when the condensing photovoltaic module 1 is at the normal position.

The sunlight Ls passes through a state (FIG. 4(C)) in which the condensing photovoltaic module 1 is normal to the sunlight Ls again while creating the incident surface condensed light flux region FLRd on the condensing photovoltaic module 1 that has preceded the sunlight Ls (FIG. 4(B)), and then moves to the position (FIG. 4(D)) where the sunlight Ls is preceding the condensing photovoltaic module 1.

The maximum turn angle of the condensing photovoltaic module 1 that is lagging behind the sunlight Ls is, for example, -0.05 degrees with respect to the normal position. Therefore, the incident surface condensed light flux region FLRd is displaced by a distance of 1 mm (turning displacement dw) from that which is obtained when the condensing photovoltaic module 1 is at the normal position, on a side opposite to when the condensing photovoltaic module 1 is preceding the sunlight Ls.

Therefore, both when the condensing photovoltaic module 1 is preceding the sunlight Ls and when the sunlight Ls is preceding the condensing photovoltaic module 1, the turning displacement dw at the maximum turn angle of the incident surface condensed light flux region FLRd from that which is obtained when the condensing photovoltaic module 1 is normal to the sunlight Ls, can be caused to be sufficiently small for the size of the incident surface 31. Therefore, even when a positional error operation is intentionally performed by the tracking control (turning control), the light concentration characteristics are not changed, and therefore, the light concentration efficiency is not reduced.

Also, the maximum inclination angle of the inclining movement may be ±0.025 degrees, and the inclination displacement may be 0.5 mm. Specifically, the inclination displacement at the maximum inclination angle of the incident surface condensed light flux region FLRd from that which is obtained when the condensing photovoltaic module 1 is normal to the sunlight Ls, can be caused to be sufficiently small for the size of the incident surface 31. Therefore, even when a positional error operation is intentionally performed by the tracking control (inclining control), the light concentration efficiency is not reduced.

As described above, the condensing photovoltaic module 1 of this embodiment is arranged so that, when the photovoltaic cell 10 (the condensing photovoltaic module 1) is moved to a destination of the sun on the sun's orbit ahead of the sun at predetermined intervals (intermittent tracking control), the incident surface condensed light flux region FLRd is located within the incident surface 31.

Therefore, even when the intermittent tracking control is performed in which the photovoltaic cell 10 is moved to a destination of the sun ahead of the sun, variations in the light concentration characteristics of the photovoltaic cell 10 can be suppressed, thereby stabilizing the light concentration efficiency. Therefore, the output characteristics of the photovoltaic cell 10 can be stabilized, whereby high reliability can be imparted to the condensing photovoltaic module 1.

Next, the relationship between an error in a set angle (angular displacement) occurring when there is an assembly error between the condensing lens and the photovoltaic cell, and the incident surface condensed light flux region formed in the incident surface, in the condensing photovoltaic module of the embodiment of the present invention, will be described with reference to FIG. 5.

A positional error or displacement between the incident surface condensed light flux region FLRd formed in the incident surface 31 of the columnar optical member 30 and the center (the optical axis Lax) of the incident surface 31, not only occurs during operation, but also may occur due to an assembly error during the manufacturing process. Specifically, an accurate parallelism is required between the photovoltaic cell 10 (the photovoltaic cell element 11) and the condensing lens 50. However, when the condensing lens 50 and the photovoltaic cell 10 are assembled to form the condensing photovoltaic module 1, the condensing lens 50 and the photovoltaic cell 10 may deviate from the original parallelism, resulting in an angular displacement α.

When there is an assembly error between the photovoltaic cell 10 and the condensing lens 50, the sunlight Ls (the condensed light flux region FLR) condensed by the condensing lens 50 has a positional error with respect to the incident surface 31 of the columnar optical member 30. Specifically, an incident surface condensed light flux region FLRds that is laterally displaced with respect to the incident surface condensed light flux region FLRd with no positional error, is formed in the incident surface 31 of the columnar optical member 30.

As shown in FIG. 4 (FIG. 4(A)-4(D)), when the side length w of the incident surface 31 is 9.4 mm and the diameter of the incident surface condensed light flux region FLRd is 7 mm, then if the maximum value of the angular displacement α is, for example, 0.1 degree, the incident surface condensed light flux region FLRds is displaced from the original incident surface condensed light flux region FLRd by a maximum of 1 mm. In other words, even if the condensing lens 50 is displaced in any direction, the incident surface condensed light flux region FLRds can be located within the incident surface 31 of the columnar optical member 30. Therefore, it is possible to provide the condensing photovoltaic module 1 in which the light concentration efficiency is not reduced, the light concentration efficiency and the photoelectric conversion efficiency are improved, and high heat resistance and reliability are obtained.

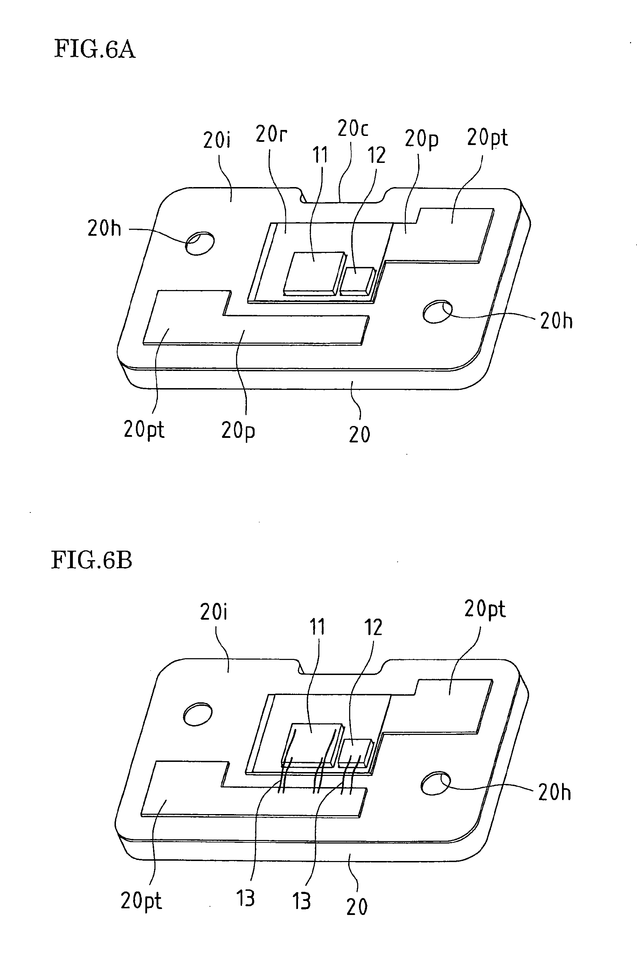

Next, a method for manufacturing the photovoltaic cell of this embodiment will be described with reference to FIGS. 6A-6K.

FIG. 6A is a perspective view for describing the method for manufacturing the photovoltaic cell of the embodiment of the present invention, where the photovoltaic cell has been mounted on the receiving substrate by die bonding.

FIG. 6B is a perspective view for describing the method for manufacturing the photovoltaic cell of the embodiment of the present invention, where the photovoltaic cell has been subjected to wire bonding.

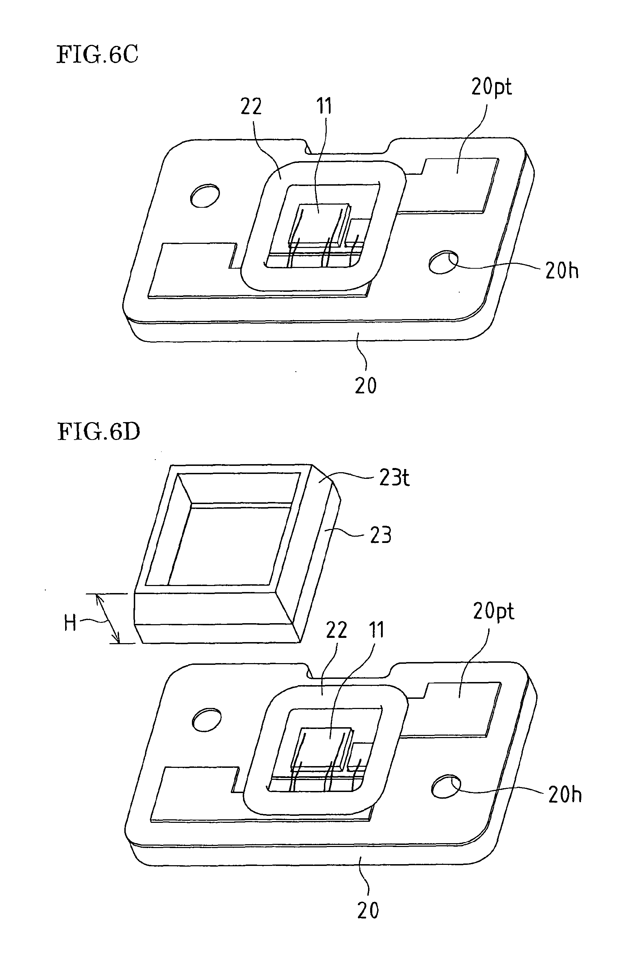

FIG. 6C is a perspective view for describing the method for manufacturing the photovoltaic cell of the embodiment of the present invention, where the inner resin sealing adhesive member to which the resin sealing member is to be attached has been formed.

FIG. 6D is an exploded perspective view for describing the method for manufacturing the photovoltaic cell of the embodiment of the present invention, where the resin sealing member has not yet been attached to the inner resin sealing adhesive member.

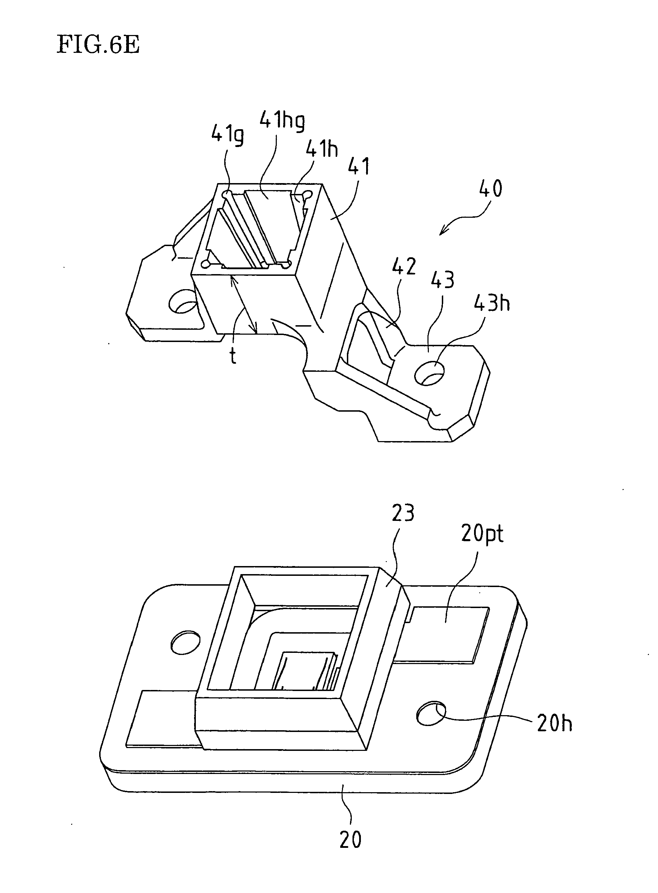

FIG. 6E is an exploded perspective view for describing the method for manufacturing the photovoltaic cell of the embodiment of the present invention, where the holder has not yet been temporarily fixed to the receiving substrate.

FIG. 6F is a plan view of the holder of FIG. 6E as viewed from above.

FIG. 6G is an exploded perspective view for describing the method for manufacturing the photovoltaic cell of the embodiment of the present invention, where the translucent resin has been injected into the inside of the confining member, and the columnar optical member has not yet been mounted on the translucent resin with the columnar optical member abutting the holder and the irradiation surface of the columnar optical member being mounted on the translucent resin.

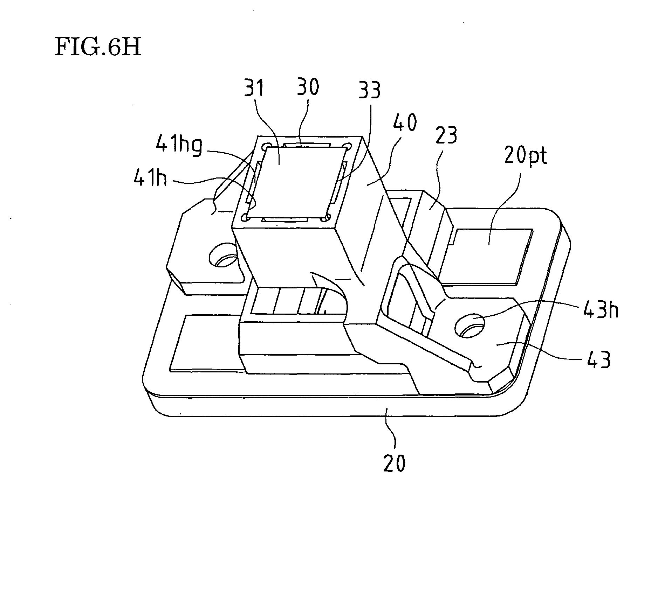

FIG. 6H is a perspective view for describing the method for manufacturing the photovoltaic cell of the embodiment of the present invention, where the columnar optical member has been mounted on the translucent resin with the columnar optical member abutting the holder and the irradiation surface of the columnar optical member being mounted on the translucent resin.

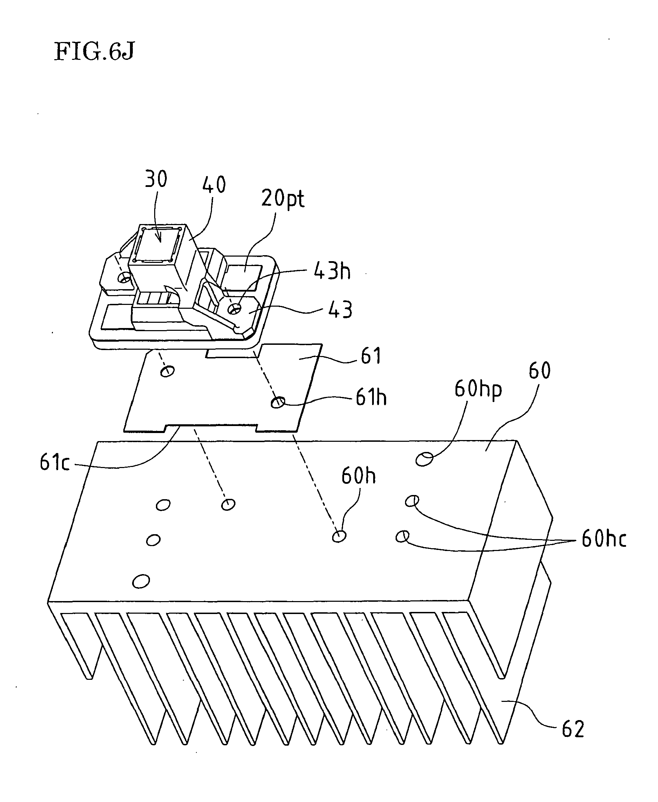

FIG. 6J is an exploded perspective view for describing the method for manufacturing the photovoltaic cell of the embodiment of the present invention, where the holder, the receiving substrate, and the heat sink have not yet been fastened together.

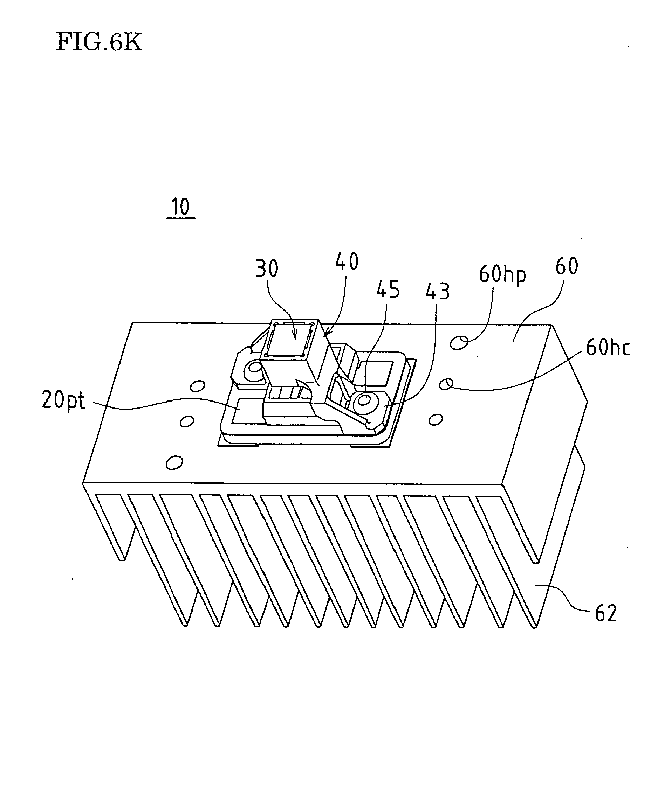

FIG. 6K is a perspective view for describing the method for manufacturing the photovoltaic cell of the embodiment of the present invention, where the holder, the receiving substrate, and the heat sink have been fastened together.

The photovoltaic cell manufacturing method of this embodiment is a method for manufacturing the photovoltaic cell 10 including the photovoltaic cell element 11 that converts the sunlight Ls condensed by the condensing lens 50 into electricity, the receiving substrate 20 on which the photovoltaic cell element 11 is mounted, the heat sink 60 that dissipates heat coming from the receiving substrate 20, the columnar optical member 30 that has the incident surface 31 that the condensed sunlight Ls enters and the irradiation surface 32 that faces the photovoltaic cell element 11 and through which the sunlight Ls is brought to the photovoltaic cell element 11, and the holder 40 that is arranged to stand on the receiving substrate 20 and holds the columnar optical member 30.

The holder 40 includes the abutting frame 41 that abuts the side surfaces 33 of the columnar optical member 30 and has the thickness t in the direction from the incident surface 31 toward the irradiation surface 32, the supports 42 that are located away from the columnar optical member 30 and support the abutting frame 41, and the support mounting members 43 that are extended in parallel with the receiving substrate 20 outside the abutting frame 41, abut the receiving substrate 20, and are used to mount the supports 42 on the receiving substrate 20.

Also, the abutting frame 41 has the holding surfaces 41h that abut and hold the side surfaces 33 of the columnar optical member 30. The holding surfaces 41h have the side surface exposing recesses 41hg having spaces extending in the thickness-t direction of the abutting frame 33, in which the side surfaces 33 of the columnar optical member 30 are exposed (FIGS. 6E, 6F, and 6G).

Also, the photovoltaic cell manufacturing method of this embodiment includes a substrate preparing step (FIGS. 6A and 6B), a resin sealing member forming step (FIGS. 6C, 6D, and 6E), a support temporarily fixing step (FIGS. 6E and 6G), a translucent resin injecting step (FIG. 6G), a columnar optical member mounting step (FIGS. 6G and 6H), a resin sealing member forming step (FIG. 6H), and a holder fastening step (FIGS. 6J and 6K).

Initially, the receiving substrate 20 on which the photovoltaic cell element 11 has been mounted is prepared (substrate preparing step, FIGS. 6A and 6B). Specifically, the photovoltaic cell element 11 and the anti-backflow diode 12 are attached by die bonding to an interconnect pattern 20p formed on the receiving substrate 20 (FIG. 6A), and wires 13 are attached to the photovoltaic cell element 11, the anti-backflow diode 12, and another interconnect pattern 20p by wire bonding (FIG. 6B). Note that the photovoltaic cell element 11 is made of, for example, a compound semiconductor, and the anti-backflow diode 12 is made of, for example, a silicon single crystal.

The interconnect patterns 20p are provided corresponding to positive and negative electrodes of the photovoltaic cell element 11 and the anti-backflow diode 12. For example, the interconnect pattern 20p to which the photovoltaic cell element 11 and the anti-backflow diode 12 are attached by die bonding is a positive electrode, while the interconnect pattern 20p to which the photovoltaic cell element 11 and the anti-backflow diode 12 are connected by wire bonding is a negative electrode.

The interconnect patterns 20p are formed of a thin metal plate made of copper formed on an insulating film 20i formed on a surface of the receiving substrate 20. On the interconnect pattern 20p that will serve as a positive electrode, a solder resist 20r is formed around the photovoltaic cell element 11 and the anti-backflow diode 12. In other words, the solder resist 20r has an opening in each of regions in which the photovoltaic cell element 11 or the anti-backflow diode 12 is attached by die bonding.

Therefore, chip solder (not shown) is placed in the opening regions of the solder resist 20r. The photovoltaic cell element 11 and the anti-backflow diode 12 are placed on the chip solder, which is then subjected to a thermal treatment in a solder reflow furnace, whereby the photovoltaic cell element 11 and the anti-backflow diode 12 can be accurately positioned and attached by die bonding.

The interconnect pattern 20p (thin metal plate made of copper) needs to be thick enough to dissipate heat generated by the photovoltaic cell element 11 to the outside (the heat sink 60). In this embodiment, for example, the thickness of the interconnect pattern 20p is 300 µm. This thickness allows dissipation of heat from the interconnect pattern 20p to the receiving substrate 20 (the heat sink 60).

The receiving substrate 20 is in the shape of a rectangle. The photovoltaic cell element 11 and the anti-backflow diode 12 are provided at a center of the rectangle. The interconnect patterns 20p are extended from the center in a longitudinal direction, and extended end portions thereof will serve as connection terminals 20pt that are connected to the outside. By causing the receiving substrate 20 (the interconnect patterns 20p) to have a rectangular shape extended in the longitudinal direction (extended shape), the area of the receiving substrate 20 can be reduced compared to when the receiving substrate 20 has a square shape, resulting in an improvement in productivity and a reduction in cost.

The receiving substrate 20 has fastening holes 20h that are provided at symmetric positions in the vicinity of a diagonal line of the rectangle. The receiving substrate 20 also has a notch 20c in one of the long sides of the rectangle. The fastening holes 20h allow the support mounting members 43, the receiving substrate 20, the heat sink 60 to be accurately positioned and fastened together. Also, the notch 20c can be used to correctly indicate the orientation of the receiving substrate 20, whereby the receiving substrate 20 can be easily and correctly handled in the manufacturing process.

The solder resist 20r having the openings corresponding to the photovoltaic cell element 11 and the anti-backflow diode 12 accurately acts on the photovoltaic cell element 11 and the anti-backflow diode 12 when the solder chip is melted in the solder reflow furnace, whereby the photovoltaic cell element 11 and the anti-backflow diode 12 can be accurately positioned.

After the substrate preparing step, an adhesive resin is applied to the receiving substrate 20 to form the inner resin sealing adhesive member 22 inside which a translucent resin for resin sealing the photovoltaic cell element 11 is to be injected (FIG. 6 C). The inner resin sealing member 23 that prevents leakage of the translucent resin is attached to the inner resin sealing adhesive member 22 (FIGS. 6D and 6E) (resin sealing member forming step).

The inner resin sealing member 23 (the inner resin sealing adhesive member 22) is formed in the shape of a ring (frame) around the photovoltaic cell element 11 in order to inject a translucent resin for resin sealing the photovoltaic cell element 11 in a subsequent step. Also, the inner resin sealing adhesive member 22 that adheres to and fixes the inner resin sealing member 23 is formed at only a position corresponding to the inner resin sealing member 23.

The inner resin sealing member 23 is previously formed of a synthetic resin, such as PPE (Poly Phenylene Ether) or the like, and in the shape of a frame. The inner resin sealing member 23 has a function of separating, on the surface of the receiving substrate 20, an inner region where the photovoltaic cell element 11 and the anti-backflow diode 12 are provided from an outer region where the connection terminals 20pt are provided.

The inner resin sealing member 23 is covered with the holder 40. In order to prevent the inner resin sealing member 23 from contacting the holder 40, the inner resin sealing member 23 is caused to have a tapered portion 23t on an outer side thereof. Also, the height H of the frame is, for example, about 8 mm. By providing the inner resin sealing member 23, the photovoltaic cell element 11 can be reliably separated from the surroundings (outside).

After the resin sealing member forming step, the holder 40 and the receiving substrate 20 are positioned and temporarily fixed to each other (support temporarily fixing step, FIGS. 6E and 6G). Specifically, the fastening holes 43h of the support mounting members 43 are positioned to coincide with the fastening holes 20h of the receiving substrate 20, thereby the holder 40 is positioned with respect to the receiving substrate 20 (FIG. 6E shows a state just before the holder 40 and the receiving substrate 20 are positioned), and the holder 40 (the support mounting members 43) is temporarily fixed to the receiving substrate 20 (FIG. 6G shows a state in which the holder 40 and the receiving substrate 20 are temporarily fixed to each other).

The temporarily fixing is, for example, performed as follows. An adhesive resin is applied to side surfaces of the support mounting members 43 and a surface of the receiving substrate 20, and the receiving substrate 20 and the holder 40 are lightly attached to each other. Alternatively, a positioning pin (not shown) may be caused to penetrate the fastening hole 20h and the fastening hole 43h, for example.

Note that FIG. 6F shows the positional relationship as viewed from above between the abutting frame 41, the supports 42, the support mounting members 43, and the fastening holes 43h. As described above with reference to FIGS. 1A-1C, the abutting frame 41 is in the shape of a rectangle corresponding to the side surfaces 33, and the supports 42 are arranged in the shape of columns extending from the abutting frame 41.

Also, in FIG. 6F, the positions of the photovoltaic cell element 11 and the fastening member 45 are indicated by dot-dot-dash lines. As described above with reference to FIGS. 1A-1C, the photovoltaic cell element 11 is positioned to coincide with the center of the abutting frame 41, and the fastening members 45 are positioned to coincide with the fastening holes 43h.

The support mounting members 43 are extended in parallel with the receiving substrate 20 and abut the receiving substrate 20 outside the abutting frame 41, and are diagonally aligned with respect to a crossing line CL intersecting opposite sides of the photovoltaic cell element 11 at middles thereof at right angles. Also, the support mounting members 43 are arranged at positions rotationally symmetric (2-fold rotational symmetry) about the center of the photovoltaic cell element 11, and are fastened to the receiving substrate 20 and the heat sink 60.

Also, the abutting frame 41 has the holding surfaces 41h that abut and hold the side surfaces 33 of the columnar optical member 30. The holding surfaces 41h have the side surface exposing recesses 41hg having spaces extending in the thickness-t direction of the abutting frame 41, in which the side surfaces 33 of the columnar optical member 30 are exposed (FIGS. 6E, 6F, and 6G). In the side surface exposing recess 41hg, the side surface 33 is exposed so that thermal energy applied to the columnar optical member 30 is discharged to the space, and total reflection is allowed on the side surface 33, whereby the heat dissipation characteristics and the light concentration characteristics can be improved.

By arranging the support mounting members 43 at positions diagonally aligned with respect to the crossing line CL, the distance between the support mounting member 43 and the photovoltaic cell element 11 can be increased as much as possible. Therefore, heat absorbed the abutting frame 41 can be dissipated via the receiving substrate 20 to the heat sink 60 at a position where the influence of the heat on the photovoltaic cell element 11 is reduced to the extent possible, whereby a reduction in the photoelectric conversion efficiency of the photovoltaic cell element 11 can be prevented, resulting in high power generation efficiency.

After the support temporarily fixing step, a translucent resin is injected via an inner space formed by the abutting frame 41 into the inside of the inner resin sealing member 23 (translucent resin injecting step, note that FIG. 6G shows a state after the injection of the translucent resin has been completed). Specifically, a space between the surface of the photovoltaic cell element 11 and the irradiation surface 32 is filled with the translucent resin. As described above, examples of the translucent resin include epoxy resins, silicone resins, and the like.

After the translucent resin injecting step, the columnar optical member 30 is caused to abut the abutting frame 41, so that the irradiation surface 32 of the columnar optical member 30 is mounted on the translucent resin (columnar optical member mounting step, FIGS. 6G and 6H). FIG. 6G shows a state before the columnar optical member 30 is caused to abut the abutting frame 41. FIG. 6H shows a state after the columnar optical member 30 is caused to abut the abutting frame 41, so that the irradiation surface 32 of the columnar optical member 30 is mounted on the translucent resin.

During the state of FIG. 6H, the translucent resin is cured to form the resin sealing member 25 (resin sealing member forming step). By forming the resin sealing member 25, the columnar optical member 30 can be reliably attached to the resin sealing member 25. Also, by heating the translucent resin to an appropriate temperature, defoaming can be performed simultaneously with curing, whereby the resin sealing member 25 having excellent translucency can be formed. Note that the corner recess 41g can serve as a path for defoaming.

The irradiation surface 32 of the columnar optical member 30 is mounted on and contacts the translucent resin (the resin sealing member 25). Therefore, the irradiation surface 32 of the columnar optical member 30 is attached by the translucent resin of the resin sealing member 25, whereby the columnar optical member 30 can be reliably and accurately fixed to the photovoltaic cell element 11. Note that, by injecting an adhesive resin into the corner recesses 41g, the columnar optical member 30 and the holder 40 are attached and fixed to each other by the corner recesses 41g, whereby the mechanical strength can be further ensured.

After the resin sealing member forming step, the support mounting members 43 are fastened to the receiving substrate 20 and the heat sink 60 (holder fastening step, FIGS. 6J and 6K). A heat conductive sheet 61 that is used to tightly attach the receiving substrate 20 and the heat sink 60 together to improve heat dissipation performance is interposed at an interface between the receiving substrate 20 and the heat sink 60. A notch 61c for identifying the orientation of the heat conductive sheet 61 is formed in the heat conductive sheet 61. Also, fastening holes 61h through which the fastening members 45 will penetrate are formed in the heat conductive sheet 61.

The fastening members 45 penetrate the fastening holes 43h of the holder 40 (the support mounting members 43), the fastening holes 20h of the receiving substrate 20, the fastening holes 61h of the heat conductive sheet 61, and fastening holes 60h of the heat sink 60, which have been positioned, whereby the holder 40 (the support mounting members 43), the receiving substrate 20, the heat conductive sheet 61, and the heat sink 60 can be accurately positioned and reliably fastened together.

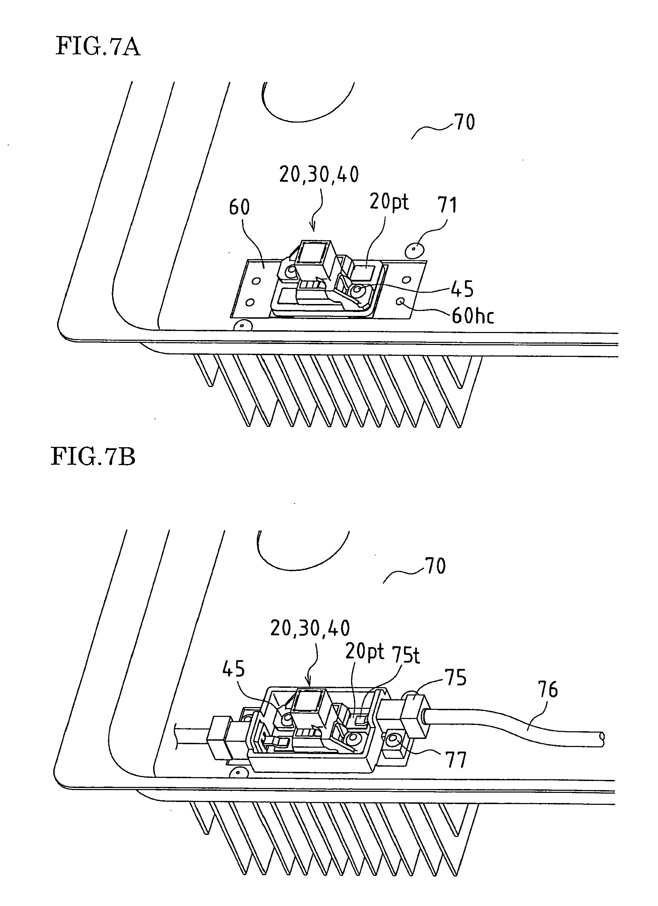

Note that mounting holes 60hp for mounting and fastening the heat sink 60 to the module plate 70 (see FIGS. 7A) are formed in the heat sink 60, and also, connector holes 60hc for fastening the connectors 75 (see FIG. 7B) are formed in the heat sink 60.

The heat sink 60 has a flat surface larger than the receiving substrate 20 and is fastened to the receiving substrate 20. The heat sink 60 also has fins 62 on a surface thereof opposite to that on which the receiving substrate 20 is provided.

As described above, the photovoltaic cell manufacturing method of this embodiment includes the substrate preparing step, the resin sealing member forming step, the support temporarily fixing step, the translucent resin injecting step, the columnar optical member mounting step, the resin sealing member forming step, and the holder fastening step.

As described above, the photovoltaic cell manufacturing method of this embodiment includes the substrate preparing step, the resin sealing member forming step, the support temporarily fixing step, the translucent resin injecting step, the columnar optical member mounting step, the resin sealing member forming step, and the holder fastening step. Therefore, the columnar optical member 30 that efficiently brings the sunlight Ls condensed on the incident surface 31 of the columnar optical member 30 through the irradiation surface 32 to the photovoltaic cell element 11 can be easily and accurately combined with the holder 40 (the abutting frame 41, the holding surfaces 41h). Therefore, the holder 40 (the support mounting members 43), the receiving substrate 20, and the heat sink 60 that are used to dissipate the thermal energy of the condensed sunlight Ls applied to the columnar optical member 30 and the abutting frame 41 at a position away from the photovoltaic cell element 11, can be easily and accurately assembled. As a result, the photovoltaic cell 10 in which the heat dissipation characteristics and the light concentration characteristics are improved, and high photoelectric conversion efficiency, resistance, and reliability are obtained, can be manufactured with high productivity (i.e., easily and accurately) and low cost.

A condensing photovoltaic module including the photovoltaic cell 10 manufactured by the aforementioned manufacturing method will be described with reference to FIGS. 7A and 7B.

FIG. 7A is a perspective view of the condensing photovoltaic module of the embodiment of the present invention in which the photovoltaic cell is mounted on the module plate.

FIG. 7B is a perspective view of the condensing photovoltaic module of FIG. 7A in which connectors and connector leads are connected to the photovoltaic cell.

The heat sink 60 is fastened (mounted) to the module plate 70, which is a major part of the condensing photovoltaic module 1, by the plate fastening members 71 penetrating the mounting holes 60hp (FIG. 7A). Therefore, the photovoltaic cell 10 can be accurately and reliably positioned with respect to the module plate 70 (the condensing photovoltaic module 1).

Also, the plate fastening member 71 may be similar to the fastening member 45. The plate fastening member 71 may be, for example, a rivet in terms of workability, accuracy, and mechanical strength.

A terminal (the connector terminal 75t) of the connector 75 is connected to the connection terminal 20pt using, for example, solder. Also, the connector 75 is connected via the connector lead 76 to the outside. The connector 75 is fastened to the connector hole 60hc by the connector fastening member 77. Therefore, the connection terminal 20pt is accurately and reliably connected to the outside. The connector fastening member 77 may be similar to the plate fastening member 71.

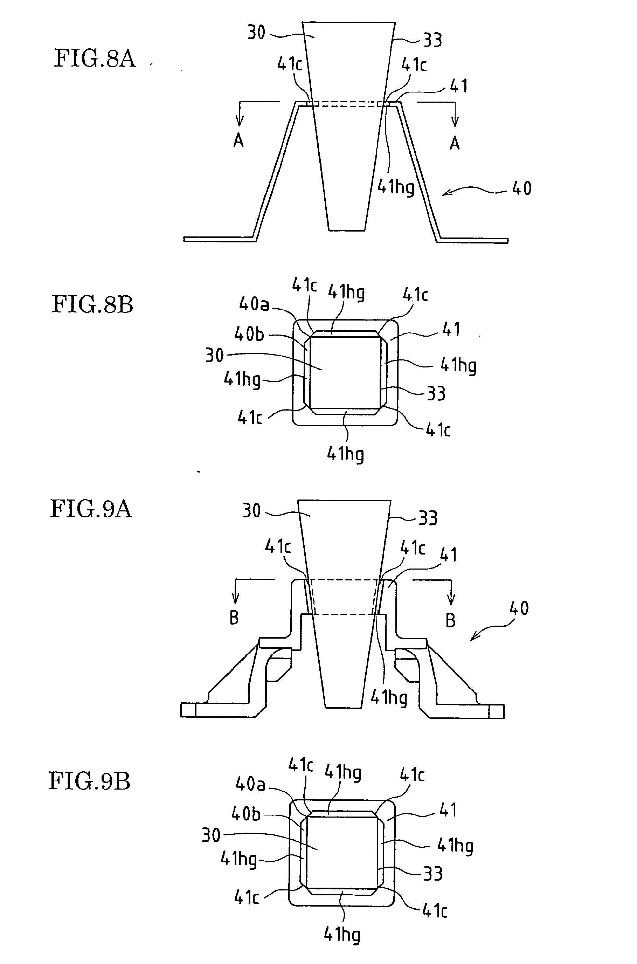

In the above embodiment, the abutting frame 41 has the holding surfaces 41h that face, abut, and hold the side surfaces 33 of the columnar optical member 30. The present invention is not limited to this. The abutting frame 41 may abut the columnar optical member 30 in other ways. The abutting frame 41 may abut the columnar optical member 30 at inner corner portions of the abutting frame 41 that face the corners of the columnar optical member 30. Also in this case, an advantage similar to that of the above embodiment is obtained. FIGS. 8A, 8B, 9A, and 9B show the abutting frame 41 and the columnar optical member 30, where the abutting frame 41 abuts the columnar optical member 30 at the inner corner portions.

The inner corner portions of the abutting frame 41 of the holder 40 shown in FIGS. 8A and 8B are beveled. Therefore, entire side surfaces (facing the side surfaces 33 of the columnar optical member 30) of the abutting frame 41 form side surface exposing recesses 41hg in which the side surfaces 33 of the columnar optical member 30 are exposed.

In the abutting frame 41, the beveled inner corner portions serve as corner holders 41c that hold the columnar optical member 30. As shown in FIGS. 8A and 8B, the corner holders 41c at the four corners of the abutting frame 41 abut the four corners of the columnar optical member 30 at upper surface edges of the corner holders 41c. Specifically, the corner holder 41c of the abutting frame 41 abuts the columnar optical member 30 at a point. Note that, in the case of the form shown in FIGS. 8A and 8B, the columnar optical member 30 abuts the abutting frame 41 at a middle portion in the thickness direction of the columnar optical member 30.

Also, FIGS. 9A and 9B show another abutting frame 41 in which the inner corner portions are beveled, and the entire side surfaces (facing the side surfaces 33 of the columnar optical member 30) form side surface exposing recesses 41hg in which the side surfaces 33 of the columnar optical member 30 are exposed.

In this abutting frame 41, the beveled inner corner portions serve as corner holders 41c that hold the columnar optical member 30. As shown in FIGS. 9A and 9B, the corner holders 41c at the four corners of the abutting frame 41 abut the four corners of the columnar optical member 30. Specifically, the corner holder 41c of the abutting frame 41 abuts the columnar optical member 30 at a line. Note that, in the case of the form shown in FIGS. 9A and 9B, the columnar optical member 30 abuts the abutting frame 41 at a middle portion in the thickness direction of the columnar optical member 30.

The present invention can be embodied and practiced in other different forms without departing from the spirit and essential characteristics thereof. Therefore, the above-described embodiments are considered in all respects as illustrative and not restrictive. The scope of the invention is indicated by the appended claims rather than by the foregoing description. All variations and modifications falling within the equivalency range of the appended claims are intended to be embraced therein.

This application claims priority on Patent Application No. 2008-230259 filed in Japan on September 8, 2008 and Patent Application No. 2008-230260 filed in Japan on September 8, 2008, which are hereby incorporated by reference in its entirety. All documents cited herein are also specifically incorporated by reference in their entirety.

### Industrial Applicability

The present invention is applicable to tracking condensing photovoltaic cells and condensing photovoltaic modules. Description of Reference Characters

- 1: condensing photovoltaic module
- 5: tracking controller
- 10: photovoltaic cell
- 11: photovoltaic cell element
- 20: receiving substrate
- 20p: interconnect pattern
- 20pt: connection terminal
- 20h: fastening hole
- 22: inner resin sealing adhesive member
- 23: resin sealing member
- 25: resin sealing member
- 30: columnar optical member
- 30w: gravity center
- 31: incident surface
- 32: irradiation surface
- 33: side surface
- 40: holder
- 40a: abutting portion
- 40b: non-abutting portion
- 41: abutting frame
- 41b: bottom portion
- 41c: corner holder
- 41g: corner recess
- 41h: holding surface
- 41hg: side surface exposing recess
- 42: support
- 43: support mounting member
- 43h: fastening hole
- 45: fastening member
- 50: condensing lens
- 60: heat sink
- 60h: fastening hole
- 60hc: connector hole
- 60hp: mounting hole
- 61: heat conductive sheet
- 61h: fastening hole
- 70: module plate
- 71: plate fastening member
- 75: connector
- 75t: connector terminal
- 77: connector fastening member
- CL: crossing line
- FLR: condensed light flux region
- FLRb: short-to-medium wavelength condensed light flux region
- FLRc: long wavelength condensed light flux region
- FLRcs: outer peripheral region
- FLRd: incident surface condensed light flux region
- FLRs: smallest condensed light flux region
- FLR(T1): condensed light flux region (temperature T1)
- FLR(T2): condensed light flux region (temperature T2)
- FLR(T3): condensed light flux region (temperature T3)
- FLRd(T1): incident surface condensed light flux region (temperature T1)
- FLRd(T2): incident surface condensed light flux region (temperature T2)
- FLRd(T3): incident surface condensed light flux region (temperature T3)
- FP: focus
- FPg: focus group
- FP(T1): focus (temperature T1)
- FP(T2): focus (temperature T2)
- FP(T3): focus (temperature T3)
- Lax: optical axis
- Ls: sunlight
- Sfp: focus shift
- SSD: sun's movement direction
- t: thickness
- α: angular displacement
- θ: slanting angle (slanting of side surface 33)

## Claims

1. A photovoltaic cell comprising:
a photovoltaic cell element configured to convert sunlight into electricity;
a columnar optical member including an incident surface that the sunlight enters, a side surface by which the sunlight is reflected, and an irradiation surface through which the sunlight is brought to the photovoltaic cell element; and
a holder configured to hold the columnar optical member,
wherein a facing portion that is faced the columnar optical member of the holder includes an abutting portion configured to abut the columnar optical member, and a non-abutting portion located away from the columnar optical member.

2. The photovoltaic cell according to claim 1, wherein
a facing surface that is faced the columnar optical member of the holder includes a holding surface configured to hold a side surface of the columnar optical member, and a side surface exposing recess configured to expose the side surface of the columnar optical member.

3. The photovoltaic cell according to claim 2, wherein
the side surface of the columnar optical member includes a flat surface, and
the side surface exposing recess includes a position facing a middle portion of the flat surface.

4. The photovoltaic cell according to claim 1, wherein
the facing portion that is faced the columnar optical member of the holder includes a corner holder configured to hold a corner of the columnar optical member, and a side surface exposing recess configured to expose the side surface of the columnar optical member.

5. The photovoltaic cell according to any one of claims 1-4, comprising:
a receiving substrate on which the photovoltaic cell element is mounted,
wherein the holder includes an abutting frame configured to abut the columnar optical member, a support located away from the columnar optical member and configured to support the abutting frame, and a support mounting member located away from the photovoltaic cell element and configured to mount the support on the receiving substrate.

6. The photovoltaic cell according to claim 5, wherein
the abutting frame is in the shape of a rectangle corresponding to the side surface of the columnar optical member, and
the holding surface is extended in a thickness direction of the abutting frame to a position that allows the holding surface to support a gravity center of the columnar optical member.

7. The photovoltaic cell according to claim 5 or 6, wherein
the abutting frame is in the shape of a rectangle corresponding to the side surface of the columnar optical member,
the support is in the shape of a column extending from the abutting frame, and
the support mounting member is extended from the support in parallel with a mounting surface of the receiving substrate and in a direction away from the photovoltaic cell element while abutting the receiving substrate, is diagonally deflected with respect to a crossing line intersecting a side of the photovoltaic cell element at middle thereof at a right angle, is arranged at a position rotationally symmetric about a center point of the photovoltaic cell element, and is fastened to the receiving substrate.

8. The photovoltaic cell according to any one of claims 1-7, wherein
the side surface of the columnar optical member is sloped so that the sunlight entering the incident surface is totally reflected toward the irradiation surface, and
the incident surface of the columnar optical member is a size to accommodate within the incident surface an incident surface light flux region formed in the incident surface by a light flux region formed by the sunlight.

9. The photovoltaic cell according to claim 8, wherein
the side surface of the columnar optical member is sloped by 8-20 degrees with respect to a direction normal to the irradiation surface.

10. The photovoltaic cell according to any one of claims 1-9, wherein
the irradiation surface of the columnar optical member is a size to be accommodated within the photovoltaic cell element.

11. The photovoltaic cell according to any one of claims 1-10, wherein
the columnar optical member and the holder are arranged so that a smallest light flux region that is a smallest of light flux regions formed by the sunlight is located closer to the incident surface of the columnar optical member than a side closer to the photovoltaic cell element of the holder.

12. A condensing photovoltaic module comprising:
the photovoltaic cell according to any one of claims 1-11; and
a condensing lens configured to condense sunlight and bring the condensed sunlight to the photovoltaic cell.

13. The condensing photovoltaic module according to claim 12, wherein
a smallest light flux region that is a smallest of light flux regions formed by the sunlight is located within the columnar optical member.

14. The condensing photovoltaic module according to claim 12 or 13, wherein
the photovoltaic cell includes a receiving substrate on which the photovoltaic cell element is mounted,
the holder includes an abutting frame configured to abut the columnar optical member, a support located away from the columnar optical member and configured to support the abutting frame, and a support mounting member located away from the photovoltaic cell element and configured to mount the support on the receiving substrate, and
the abutting frame is thick enough to block an outer peripheral region of a long wavelength light flux region formed by a long wavelength portion of the sunlight.

15. The condensing photovoltaic module according to any one of claims 12-14, wherein
an intermittent tracking control is performed to move a position of the photovoltaic cell to a destination of the sun on the sun's orbit ahead of the sun at predetermined intervals, and
an incident surface light flux region formed in the incident surface of the columnar optical member is located within the incident surface of the columnar optical member.

16. A method for manufacturing a photovoltaic cell, wherein
the photovoltaic cell includes:
a photovoltaic cell element configured to convert sunlight into electricity;
a receiving substrate on which the photovoltaic cell element is mounted;
a columnar optical member including an incident surface that the sunlight enters, a side surface by which the sunlight is reflected, and an irradiation surface through that the sunlight is brought to the photovoltaic cell element; and
a holder configured to hold the columnar optical member,
wherein the holder includes an abutting frame configured to abut the columnar optical member, a support located away from the columnar optical member and configured to support the abutting frame, and a support mounting member located away from the photovoltaic cell element and configured to mount the support on the receiving substrate,
the method comprises:
a substrate preparing step of preparing the receiving substrate on which the photovoltaic cell element is mounted;
a resin confining member forming step of applying an adhesive resin to the receiving substrate, forming an inner resin confining adhesive member into inside of which a translucent resin for encapsulating the photovoltaic cell element is injected, and attaching an resin confining member configured to prevent leakage of the translucent resin to the inner resin confining adhesive member;
a support temporarily fixing step of positioning and temporarily fixing the holder and the receiving substrate to each other;
a translucent resin injecting step of injecting the translucent resin into inside of the resin confining member;
a columnar optical member mounting step of causing the columnar optical member to abut the abutting frame to mount the irradiation surface on the translucent resin;
a resin sealing member forming step of curing the translucent resin to form the a resin sealing member; and
a holder fastening step of fastening the support mounting member to the receiving substrate.

17. The photovoltaic cell manufacturing method according to claim 16, wherein
a facing portion that is faced the columnar optical member of an abutting frame of the holder includes a holding surface configured to hold a side surface of the columnar optical member, and a side surface exposing recess configured to expose the side surface of the columnar optical member.
